# EUROPEAN PATENT APPLICATION

(11) **EP 4 297 495 A1**
(43) Date of publication of application: **27.12.2023**
(21) Application number: 22766185.7
(22) Date of filing: 01.03.2022
(51) Int. Cl.: H04W 52/02, H04L 25/03

(54) **COMMUNICATION METHOD AND COMMUNICATION APPARATUS**

(30) Priority: 09.03.2021 CN 202110254900
(71) Applicant: Huawei Technologies Co., Ltd., Shenzhen, Guangdong 518129 (CN)
(72) Inventor: WANG, Jian, Shenzhen, Guangdong 518129 (CN); ZHANG, Gongzheng, Shenzhen, Guangdong 518129 (CN); LI, Rong, Shenzhen, Guangdong 518129 (CN); WANG, Jun, Shenzhen, Guangdong 518129 (CN); TONG, Wen, Shenzhen, Guangdong 518129 (CN)
(74) Representative: Maiwald GmbH
(86) International application number: PCT/CN2022/078559
(87) International publication number: WO 2022/188659

(57) **Abstract**

Embodiments of this application disclose a communication method and a communication apparatus, to reduce a PAPR of a signal sent by a sending device by using an FDSS waveform processing manner, and reduce decoding power consumption of a receiving device by using a polar code encoding manner. This improves communication energy efficiency. In this method, the sending device performs frequency domain spectrum shaping FDSS processing on a first signal, to obtain a second signal, where the first signal is a signal obtained by performing polar code encoding based on a modulation and coding scheme; and then, the sending device sends a target signal to the receiving device, where the target signal is a signal obtained based on the second signal.

## Description

This application claims priority to Chinese Patent Application No. 202110254900.9, filed with the China National Intellectual Property Administration on March 09, 2021 and entitled "COMMUNICATION METHOD AND COMMUNICATION APPARATUS", which is incorporated herein by reference in its entirety.

### TECHNICAL FIELD

This application relates to the communication field, and in particular, to a communication method and a communication apparatus.

### BACKGROUND

Wireless communication refers to transmission communication between a plurality of communication nodes without propagation that is performed through a conductor or a cable. Generally, a communication manner in which a communication distance is within hundreds of meters (or tens of meters) may be referred to as short-range communication.

Currently, in the short-range communication, a communication distance between a sending device and a receiving device is short, and a frequency band signal of a high frequency may be used for communication. A frequency band of the high frequency may provide a wider system bandwidth, and high-power signals may be easily transmitted and received, to improve a throughput rate of a communication system.

However, when the throughput rate is improved, power consumption of the sending device and power consumption of the receiving device are easily increased. Therefore, how to implement a low-power short-range wireless communication technology is a technical problem to be urgently resolved.

### SUMMARY

Embodiments of this application provide a communication method and a communication apparatus, to reduce a peak to average power ratio (peak to average power ratio, PAPR) of a signal sent by a signal sending device by using a frequency domain spectral shaping (frequency domain spectral shaping, FDSS) waveform processing manner. In addition, a coding manner of polar (Polar) encoding is used to reduce decoding power consumption of a receiving device. This improves communication energy efficiency.

A first aspect of embodiments of this application provides a communication method. The method is applied to a first communication apparatus used as a sending device. Specifically, the method may be performed by a terminal device (or a network device), or may be performed by a component (for example, a processor, a chip, or a chip system) of a terminal device (or a network device). An operating frequency band of the first communication apparatus is between 30 gigahertz GHz and 300 GHz. The frequency band may also be referred to as a millimeter wave frequency band or an extremely high frequency (extremely high frequency, EHF) frequency band. In this method, the first communication apparatus used as the sending device first performs frequency domain spectrum shaping FDSS processing on a first signal, to obtain a second signal, where the first signal is a signal obtained by performing polar encoding based on a modulation and coding scheme; and then, the first communication apparatus sends a target signal to another communication apparatus (for example, a second communication apparatus) that is used as a receiving device, where the target signal is a signal obtained based on the second signal.

Based on the foregoing technical solution, the sending device performs FDSS processing on the first signal obtained by performing polar encoding based on the modulation and coding scheme, to obtain the second signal, and sends, to the receiving device, the target signal obtained based on the second signal. In the communication method, the second signal is obtained by using FDSS waveform processing, so that a PAPR of the target signal sent by the sending device can be reduced, to reduce costs and power consumption of a transmitter. In addition, a polar encoding manner is used to obtain the first signal. Compared with high power consumption in a decoding process in a conventional encoding manner of a low density parity code (low density parity code, LDPC), decoding power consumption of the receiving device of the target signal can be reduced, and communication energy efficiency can be improved.

In a possible implementation of the first aspect of embodiments of this application, that the first communication apparatus used as a sending device performs frequency domain spectrum shaping FDSS processing on a first signal, to obtain a second signal includes: The first communication apparatus first performs discrete fourier transform (discrete fourier transform, DFT) processing on the first signal, to obtain a third signal; and then, the first communication apparatus performs filtering processing on the third signal, to obtain the second signal.

Based on the foregoing technical solution, DFT processing is used to perform transform processing on a time domain signal to obtain a frequency domain signal. In a process of performing FDSS processing on the first signal, the sending device may first perform DFT processing on the first signal, to obtain a third signal, and then perform filtering processing on the third signal, to obtain a spread second signal.

It should be noted that as a special implementation form of the DFT, fast fourier transform (fast fourier transform, FFT) is a fast algorithm for implementing the DFT. Therefore, the foregoing DFT processing process may also be implemented through an FFT processing process.

In a possible implementation of the first aspect of embodiments of this application, the third signal is a signal obtained by performing processing based on a first DFT point quantity, and the target signal is a signal obtained by performing inverse discrete fourier transform (inverse discrete fourier transform, IDFT) processing on the second signal based on a second DFT point quantity.

Based on the foregoing technical solution, IDFT processing is used to perform transform processing on the frequency domain signal to obtain the time domain signal, and the third signal may be specifically a signal obtained by performing DFT processing on the first signal based on the first DFT point quantity. The target signal may be a signal obtained by performing IDFT processing on the second signal based on the second DFT point quantity. When the first DFT point quantity is less than a second IDFT point quantity, spectrum spreading may be performed on the second signal, to implement FDSS processing to obtain a target signal with a lower PAPR.

It should be noted that the target signal is a signal obtained by performing, at least based on the second DFT point quantity, inverse fourier transform IDFT processing on the second signal. Another processing process, for example, cyclic prefix (cyclic prefix, CP) addition, parallel/serial (P/S) conversion, or another processing process may alternatively be performed, which is not limited herein.

Similarly, as a special implementation form of the IDFT, inverse fast fourier transform (inverse fast fourier transform, IFFT) is a fast algorithm for implementing the IDFT, and the foregoing IDFT processing process may also be implemented through an IFFT processing process.

In a possible implementation of the first aspect of embodiments of this application, a numerical ratio of the first DFT point quantity to the second DFT point quantity is 2 to 3.

Based on the foregoing technical solution, because the numerical ratio of the first DFT point quantity to the second DFT point quantity is 2 to 3, it can be learned that a maximum alpha value of a filter (filter) used to implement filtering processing may be 0.5. The alpha value of the filter is used to limit a design of the filter. For example, when a root-raised cosine filter is used, the alpha value is a roll-off factor of the root-raised cosine filter. A design of a filter required by the sending device may be conveniently guided based on the alpha value.

Optionally, when the numerical ratio of the first DFT point quantity to the second DFT point quantity is 2 to 3, a value of the first DFT point quantity may be 512, and a value of the second DFT point quantity may be 768; or a value of the first DFT point quantity may be 1024, and a value of the second DFT point quantity may be 1536; or another value combination, which is not limited herein.

In a possible implementation of the first aspect of embodiments of this application, a numerical ratio of the first DFT point quantity to the second DFT point quantity is 4 to 5.

Based on the foregoing technical solution, because the numerical ratio of the first DFT point quantity to the second DFT point quantity is 4 to 5, it can be learned that a maximum alpha value of a filter (filter) used to implement filtering processing may be 0.25. The alpha value of the filter is used to limit a design of the filter. For example, when a root-raised cosine filter is used, the alpha value is a roll-off factor of the root-raised cosine filter. A design of a filter required by the sending device may be conveniently guided based on the alpha value.

Optionally, when the numerical ratio of the first DFT point quantity to the second DFT point quantity is 4 to 5, a value of the first DFT point quantity may be 512, and a value of the second DFT point quantity may be 640; or a value of the first DFT point quantity may be 1024, and a value of the second DFT point quantity may be 1280; or another value combination, which is not limited herein.

In a possible implementation of the first aspect of embodiments of this application, a sampling rate (or referred to as a baseband sampling rate) of a baseband signal of the first communication apparatus is a positive integer multiple of 30.72 megahertz MHz.

Based on the foregoing technical solution, to support normal operation of the first communication apparatus in another communication system (a communication system limiting the sampling rate of the baseband signal to 30.72 MHz), the sampling rate of the baseband signal of the first communication apparatus may be set to the positive integer multiple of 30.72 MHz, to improve compatibility of the first communication apparatus in different communication systems, and flexible configuration may also be performed based on a system bandwidth of the communication system, to further improve communication energy efficiency.

It should be noted that the sampling rate of the baseband signal of the first communication apparatus is the positive integer multiple of 30.72 MHz. For example, when the system bandwidth is 2.5 GHz, a value of the positive integer multiple may be 8, namely, 2.4576 GHz; or when the system bandwidth is 5.0 GHz, a value of the positive integer multiple may be 16, namely, 4.9152 GHz; or when the system bandwidth is 7.5 GHz, a value of the positive integer multiple may be 24, namely, 7.3728 GHz; or when the system bandwidth is 10.0 GHz, a value of the positive integer multiple may be 32, namely, 9.8304 GHz; or a value of the positive integer multiple is another value, and is not limited herein. In other words, different multiples of the positive integer multiple of 30.72 MHz are selected in different system bandwidths, so that spectrum utilization of a communication system in which the first communication apparatus is located is improved on a premise that compatibility of the first communication apparatus in different communication systems is improved.

In a possible implementation of the first aspect of embodiments of this application, a code rate of the modulation and coding scheme includes at least 15/16.

Based on the foregoing technical solution, the first signal is a signal obtained by performing polar encoding based on the modulation and coding scheme. In other words, the sending device performs polar encoding on to-be-sent bit information based on the modulation and coding scheme to obtain the first signal. Specifically, the modulation and coding scheme may include a plurality of pieces of configuration information. In addition, any piece of configuration information includes at least a code rate. When a code rate of the modulation and coding scheme includes 15/16, compared with another code rate (for example, 1/2, 3/4, 7/8, or the like) implementation commonly used in a scenario in which an operating frequency band is between 30 gigahertz GHz and 300 GHz, a high throughput rate may be achieved by using a high code rate, to meet a requirement for a high throughput rate in a short-range wireless communication technology.

Optionally, the code rate of the modulation and coding scheme may further include one or more of 1/2, 3/4, 5/8, 7/8, and 13/16.

It should be noted that the modulation and coding scheme may be implemented in a plurality of different forms, such as a text, a table, a schematic diagram, and the like. This is not limited herein. For example, when the modulation and coding scheme is implemented through the table, the modulation and coding scheme may be a modulation and coding scheme (modulation and coding scheme, MCS) table.

In a possible implementation of the first aspect of embodiments of this application, a modulation manner of the modulation and coding scheme includes at least 8-order quadrature amplitude modulation (quadrature amplitude modulation, QAM), where the 8-order QAM may also be referred to as 8 QAM.

Based on the foregoing technical solution, the first signal is a signal obtained by performing polar encoding based on the modulation and coding scheme. In other words, the sending device performs polar encoding on to-be-sent bit information based on the modulation and coding scheme to obtain the first signal. Specifically, the modulation and coding scheme may include a plurality of pieces of configuration information. In addition, any piece of configuration information includes at least a modulation manner. When the modulation manner of the modulation and coding scheme includes the 8 QAM, compared with another modulation manner (for example, a large span from low spectral efficiency corresponding to quadrature phase shift keying (Quadrature Phase Shift Keying, QPSK) to high spectral efficiency corresponding to 16-order QAM) implementation commonly used in a scenario in which an operating frequency band is between 30 gigahertz GHz and 300 GHz. By using the modulation manner of the 8 QAM, spectral efficiency of the first communication apparatus may smoothly transition from a modulation manner of the low spectral efficiency to a modulation manner of the high spectral efficiency. This improves throughput performance of the communication system.

Optionally, the code rate of the modulation and coding scheme may further include one or more of binary phase shift keying (binary phase shift keying, BPSK), QPSK, and 16 QAM.

In a possible implementation of the first aspect of embodiments of this application, a subcarrier spacing of the target signal is a positive integer multiple of 1.6 MHz or a positive integer multiple of 1.92 MHz.

Based on the foregoing technical solution, when sending the target signal, the first communication apparatus used as the sending device may flexibly select a subcarrier spacing based on different communication scenarios. For example, when a system phase noise is large, a large subcarrier spacing may be used to improve a capability of resisting the phase noise; and when multipath interference is strong, a small subcarrier spacing may be used to increase a length of the CP. This reduces intersymbol interference and intercarrier interference, and improves communication energy efficiency.

In a possible implementation of the first aspect of embodiments of this application, the target signal further includes a cyclic prefix CP, and a time length of the CP includes at least one of the following:
26.04 nanoseconds ns, 104.16 ns, 52.08 ns, and 208.32 ns.

Based on the foregoing technical solution, when sending the target signal, the first communication apparatus used as the sending device may flexibly select a time length of the CP based on different communication scenarios. For example, when a data service transmission volume is large, a small length of the CP may be used to increase a data bandwidth part; and when the multipath interference is strong, a large length of the CP may be used. This reduces intersymbol interference and intercarrier interference, and improves communication energy efficiency.

A second aspect of embodiments of this application provides a communication method. The method is applied to a second communication apparatus used as a receiving device. Specifically, the method may be performed by a terminal device (or a network device), or may be performed by a component (for example, a processor, a chip, or a chip system) of a terminal device (or a network device). An operating frequency band of the second communication apparatus is between 30 gigahertz GHz and 300 GHz. The frequency band may also be referred to as a millimeter wave frequency band or an extremely high frequency (extremely high frequency, EHF) frequency band. In this method, the second communication apparatus used as the receiving device obtains a target signal, where the target signal is used to determine a fourth signal; and then, the second communication apparatus performs FDSS inverse processing on the fourth signal, to obtain a fifth signal, where the fifth signal is used to perform polar decoding based on a modulation and coding scheme.

Based on the foregoing technical solution, the receiving device determines the fourth signal based on the obtained target signal, and performs FDSS inverse processing on the fourth signal to obtain a fifth signal used to perform polar decoding based on the modulation and coding scheme. In the communication method, the fifth signal is obtained by using FDSS waveform inverse processing, so that a PAPR of the target signal sent by the sending device can be reduced, to reduce costs and power consumption of a transmitter. In addition, the fifth signal is used to perform decoding in a decoding manner of polar encoding. Compared with high power consumption in a decoding process of conventional low density parity code (low density parity code, LDPC) coding, decoding power consumption of the receiving device can be reduced, and communication energy efficiency can be improved.

In a possible implementation of the second aspect of embodiments of this application, a process in which the second communication apparatus performs FDSS inverse processing on the fourth signal, to obtain the fifth signal may specifically include: The first communication apparatus used as the receiving device first performs filtering processing on the fourth signal, to obtain a sixth signal; and then, the second communication apparatus performs IDFT processing on the sixth signal, to obtain the fifth signal.

Based on the foregoing technical solution, after obtaining the target signal, the second communication apparatus used as the receiving device may implement different FDSS inverse processing based on different filters in the second communication apparatus. When the target signal from the sending device is filtered by using a root-raised cosine (root-raised cosine, RRC) filter, the receiving device needs to perform filtering processing in a process of performing inverse processing on the fourth signal determined by the target signal, and performs IDFT processing after the filtering processing, to obtain the fifth signal. The IDFT processing is used to perform transform processing on a frequency domain signal to obtain a time domain signal, so that the fifth signal may subsequently obtain corresponding bit information through symbol demodulation.

In a possible implementation of the second aspect of embodiments of this application, a process in which the second communication apparatus performs FDSS inverse processing on the fourth signal, to obtain the fifth signal may specifically include: The second communication apparatus performs IDFT processing on the fourth signal, to obtain the fifth signal.

Based on the foregoing technical solution, after obtaining the target signal, the second communication apparatus used as the receiving device may implement different FDSS inverse processing based on different filters in the second communication apparatus. When the target signal from the sending device is filtered by using a raised cosine (raised cosine, RC) filter, the receiving device may not need to perform filtering processing in a process of performing inverse processing on the fourth signal determined by the target signal, to be specific, directly performs IDFT processing on the fourth signal, to obtain the fifth signal. The IDFT processing is used to perform transform processing on the frequency domain signal to obtain the time domain signal, so that the fifth signal may subsequently obtain corresponding bit information through symbol demodulation.

It should be noted that as a special implementation form of the IDFT, inverse fast fourier transform (inverse fast fourier transform, IFFT) is a fast algorithm for implementing the IDFT, and the foregoing IDFT processing process may also be implemented through an IFFT processing process.

In a possible implementation of the second aspect of embodiments of this application, the fifth signal is a signal obtained by performing processing based on a first DFT point quantity, and the fourth signal is a signal obtained by performing DFT processing on the target signal based on a second DFT point quantity.

Based on the foregoing technical solution, the fifth signal may be specifically a time domain signal that is used to perform polar decoding based on the modulation and coding scheme and that is obtained after performing IDFT processing on the sixth signal based on the first DFT point quantity. In addition, the DFT processing is used to perform transform processing on the time domain signal to obtain the frequency domain signal. In other words, the fourth signal may be a frequency domain signal obtained by performing DFT processing on the target signal based on the second DFT point quantity.

It should be noted that the target signal is used to determine the fourth signal, and may specifically indicate that the second communication apparatus may determine the fourth signal through the target signal. A specific determining process may be a signal obtained by performing DFT processing on the target signal at least based on the second DFT point quantity, and may alternatively be a signal obtained by performing another processing process, for example, serial/parallel (S/P) conversion, cyclic prefix (cyclic prefix, CP) removal, or another processing process. This is not limited herein.

Similarly, as a special implementation form of the DFT, fast fourier transform (fast fourier transform, FFT) is a fast algorithm for implementing the DFT. Therefore, the foregoing DFT processing process may also be implemented through an FFT processing process.

In a possible implementation of the second aspect of embodiments of this application, a numerical ratio of the first DFT point quantity to the second DFT point quantity is 2 to 3.

Based on the foregoing technical solution, because the numerical ratio of the first DFT point quantity to the second DFT point quantity is 2 to 3, it can be learned that a maximum alpha value of a filter (filter) used to implement filtering processing may be 0.5. The alpha value of the filter is used to limit a design of the filter. For example, when a root-raised cosine filter is used, the alpha value is a roll-off factor of the root-raised cosine filter. A design of a filter required by the sending device may be conveniently guided based on the alpha value.

Optionally, when the numerical ratio of the first DFT point quantity to the second DFT point quantity is 2 to 3, a value of the first DFT point quantity may be 512, and a value of the second DFT point quantity may be 768; or a value of the first DFT point quantity may be 1024, and a value of the second DFT point quantity may be 1536; or another value combination, which is not limited herein.

In a possible implementation of the second aspect of embodiments of this application, a numerical ratio of the first DFT point quantity to the second DFT point quantity is 4 to 5.

Based on the foregoing technical solution, because the numerical ratio of the first DFT point quantity to the second DFT point quantity is 4 to 5, it can be learned that a maximum alpha value of a filter (filter) used to implement filtering processing may be 0.25. The alpha value of the filter is used to limit a design of the filter. For example, when a root-raised cosine filter is used, the alpha value is a roll-off factor of the root-raised cosine filter. A design of a filter required by the sending device may be conveniently guided based on the alpha value.

Optionally, when the numerical ratio of the first DFT point quantity to the second DFT point quantity is 4 to 5, a value of the first DFT point quantity may be 512, and a value of the second DFT point quantity may be 640; or a value of the first DFT point quantity may be 1024, and a value of the second DFT point quantity may be 1280; or another value combination, which is not limited herein.

In a possible implementation of the second aspect of embodiments of this application, a sampling rate of a baseband signal of the second communication apparatus is a positive integer multiple of 30.72 megahertz MHz.

Based on the foregoing technical solution, to support normal operation of the second communication apparatus in another communication system (a communication system limiting the sampling rate of the baseband signal to 30.72 MHz), the sampling rate of the baseband signal of the second communication apparatus may be set to the positive integer multiple of 30.72 MHz, to improve compatibility of the second communication apparatus in different communication systems, and flexible configuration may also be performed based on a system bandwidth of the communication system, to further improve communication energy efficiency.

It should be noted that the sampling rate of the baseband signal of the second communication apparatus is a positive integer multiple of 30.72 MHz. For example, when the system bandwidth is 2.5 GHz, a value of the positive integer multiple may be 8, namely, 2.4576 GHz; or when the system bandwidth is 5.0 GHz, a value of the positive integer multiple may be 16, namely, 4.9152 GHz; or when the system bandwidth is 7.5 GHz, a value of the positive integer multiple may be 24, namely, 7.3728 GHz; or when the system bandwidth is 10.0 GHz, a value of the positive integer multiple may be 32, namely, 9.8304 GHz; or a value of the positive integer multiple is another value, and is not limited herein. In other words, different multiples of the positive integer multiple of 30.72 MHz are selected in different system bandwidths, so that spectrum utilization of a communication system in which the first communication apparatus is located is improved on a premise that compatibility of the first communication apparatus in different communication systems is improved.

In a possible implementation of the second aspect of embodiments of this application, a code rate of the modulation and coding scheme includes at least 15/16.

Based on the foregoing technical solution, the fifth signal is used to perform polar decoding based on the modulation and coding scheme. In other words, the receiving device may perform polar encoding on the fifth signal based on the modulation and coding scheme to obtain corresponding bit information. Specifically, the modulation and coding scheme may include a plurality of pieces of configuration information. In addition, any piece of configuration information includes at least a code rate. When a code rate of the modulation and coding scheme includes 15/16, compared with another code rate (for example, 1/2, 3/4, 7/8, or the like) implementation commonly used in a scenario in which an operating frequency band is between 30 gigahertz GHz and 300 GHz, a high throughput rate may be achieved by using a high code rate, to meet a requirement for a high throughput rate in a short-range wireless communication technology.

Optionally, the code rate of the modulation and coding scheme may further include one or more of 1/2, 3/4, 5/8, 7/8, and 13/16.

It should be noted that the modulation and coding scheme may be implemented in a plurality of different forms, such as a text, a table, a schematic diagram, and the like. This is not limited herein. For example, when the modulation and coding scheme is implemented through the table, the modulation and coding scheme may be a modulation and coding scheme (modulation and coding scheme, MCS) table.

In a possible implementation of the second aspect of embodiments of this application, a modulation manner of the modulation and coding scheme includes at least 8-order quadrature amplitude modulation (quadrature amplitude modulation, QAM), where the 8-order QAM may also be referred to as 8 QAM.

Based on the foregoing technical solution, the fifth signal is used to perform polar decoding based on the modulation and coding scheme. In other words, the receiving device performs polar encoding on the fifth signal based on the modulation and coding scheme to obtain corresponding bit information. Specifically, the modulation and coding scheme may include a plurality of pieces of configuration information. In addition, any piece of configuration information includes at least a modulation manner. When the modulation manner of the modulation and coding scheme includes the 8 QAM, compared with another modulation manner (for example, a large span from low spectral efficiency corresponding to quadrature phase shift keying (Quadrature Phase Shift Keying, QPSK) to high spectral efficiency corresponding to 16-order QAM) implementation commonly used in a scenario in which an operating frequency band is between 30 gigahertz GHz and 300 GHz. By using the modulation manner of the 8 QAM, spectral efficiency of the second communication apparatus may smoothly transition from a modulation manner of the low spectral efficiency to a modulation manner of the high spectral efficiency. This improves throughput performance of the communication system.

Optionally, the code rate of the modulation and coding scheme may further include one or more of binary phase shift keying (binary phase shift keying, BPSK), QPSK, and 16 QAM.

In a possible implementation of the second aspect of embodiments of this application, a subcarrier spacing of the target signal is a positive integer multiple of 1.6 MHz or a positive integer multiple of 1.92 MHz.

Based on the foregoing technical solution, when receiving the target signal, the second communication apparatus used as the receiving device may flexibly select a subcarrier spacing based on different communication scenarios. For example, when a system phase noise is large, a large subcarrier spacing may be used to improve a capability of resisting the phase noise; and when multipath interference is strong, a small subcarrier spacing may be used to increase a length of the CP. This reduces intersymbol interference and intercarrier interference, and improves communication energy efficiency.

In a possible implementation of the second aspect of embodiments of this application, the target signal further includes a cyclic prefix CP, and a time length of the CP includes at least one of the following:
26.04 nanoseconds ns, 104.16 ns, 52.08 ns, and 208.32 ns.

Based on the foregoing technical solution, when sending the target signal, the second communication apparatus used as the receiving device may flexibly select a time length of the CP based on different communication scenarios. For example, when a data service transmission volume is large, a small length of the CP may be used to increase a data bandwidth part; and when the multipath interference is strong, a large length of the CP may be used. This reduces intersymbol interference and intercarrier interference, and improves communication energy efficiency.

A third aspect of embodiments of this application provides a first communication apparatus, an operating frequency band of the first communication apparatus is between 30 GHz and 300 GHz, and the apparatus includes:
a processing unit, configured to perform FDSS processing on a first signal, to obtain a second signal, where the first signal is a signal obtained by performing polar encoding based on a modulation and coding scheme; and
a transceiver unit, configured to send a target signal, where the target signal is a signal obtained based on the second signal.

In a possible implementation of the third aspect of embodiments of this application, the processing unit is specifically configured to:
perform discrete fourier transform DFT processing on the first signal, to obtain a third signal; and
perform filtering processing on the third signal, to obtain the second signal.

In a possible implementation of the third aspect of embodiments of this application, the third signal is a signal obtained by performing processing based on a first DFT point quantity, and the target signal is a signal obtained by performing IDFT processing on the second signal based on a second DFT point quantity.

In a possible implementation of the third aspect of embodiments of this application, a numerical ratio of the first DFT point quantity to the second DFT point quantity is 2 to 3.

In a possible implementation of the third aspect of embodiments of this application, a numerical ratio of the first DFT point quantity to the second DFT point quantity is 4 to 5.

In a possible implementation of the third aspect of embodiments of this application, a sampling rate of a baseband signal of the first communication apparatus is a positive integer multiple of 30.72 megahertz MHz.

In a possible implementation of the third aspect of embodiments of this application, a code rate of the modulation and coding scheme includes at least 15/16.

In a possible implementation of the third aspect of embodiments of this application, a modulation manner of the modulation and coding scheme includes at least 8-order quadrature amplitude modulation.

In a possible implementation of the third aspect of embodiments of this application, a subcarrier spacing of the target signal is a positive integer multiple of 1.6 MHz or a positive integer multiple of 1.92 MHz.

In a possible implementation of the third aspect of embodiments of this application, the target signal further includes a cyclic prefix CP, and a time length of the CP includes at least one of the following:
26.04 nanoseconds ns, 104.16 ns, 52.08 ns, and 208.32 ns.

In the third aspect of embodiments of this application, composition modules of the first communication apparatus may be further configured to perform the steps performed in possible implementations of the first aspect. For details, refer to the first aspect. Details are not described herein again.

A fourth aspect of embodiments of this application provides a second communication apparatus, an operating frequency band of the second communication apparatus is between 30 GHz and 300 GHz, and the apparatus includes:
a transceiver unit, configured to obtain a target signal, where the target signal is used to determine a fourth signal; and
a processing unit, configured to perform FDSS inverse processing on the fourth signal, to obtain a fifth signal, where the fifth signal is used to perform polar decoding based on a modulation and coding scheme.

In a possible implementation of the fourth aspect of embodiments of this application, the processing unit is specifically configured to:
perform filtering processing on the fourth signal, to obtain a sixth signal; and
perform IDFT processing on the sixth signal, to obtain the fifth signal.

In a possible implementation of the fourth aspect of embodiments of this application, the processing unit is specifically configured to:
perform, by the second communication apparatus, IDFT processing on the fourth signal, to obtain the fifth signal.

In a possible implementation of the fourth aspect of embodiments of this application, the fifth signal is a signal obtained by performing processing based on a first DFT point quantity, and the fourth signal is a signal obtained by performing DFT processing on the target signal based on a second DFT point quantity.

In a possible implementation of the fourth aspect of embodiments of this application, a numerical ratio of the first DFT point quantity to the second DFT point quantity is 2 to 3.

In a possible implementation of the fourth aspect of embodiments of this application, a numerical ratio of the first DFT point quantity to the second DFT point quantity is 4 to 5.

In a possible implementation of the fourth aspect of embodiments of this application, a sampling rate of a baseband signal of the second communication apparatus is a positive integer multiple of 30.72 megahertz MHz.

In a possible implementation of the fourth aspect of embodiments of this application, a code rate of the modulation and coding scheme includes at least 15/16.

In a possible implementation of the fourth aspect of embodiments of this application, a modulation manner of the modulation and coding scheme includes at least 8-order quadrature amplitude modulation.

In a possible implementation of the fourth aspect of embodiments of this application, a subcarrier spacing of the target signal is a positive integer multiple of 1.6 MHz or a positive integer multiple of 1.92 MHz.

In a possible implementation of the fourth aspect of embodiments of this application, the target signal further includes a cyclic prefix CP, and a time length of the CP includes at least one of the following:
26.04 nanoseconds ns, 104.16 ns, 52.08 ns, and 208.32 ns.

In the fourth aspect of embodiments of this application, composition modules of the second communication apparatus may be further configured to perform the steps performed in possible implementations of the second aspect. For details, refer to the second aspect. Details are not described herein again.

A fifth aspect of embodiments of this application provides a communication apparatus, including at least one processor, where the at least one processor is coupled to a memory;
the memory is configured to store a program or instructions; and
the at least one processor is configured to execute the program or the instructions, so that the apparatus implements the method in the first aspect or any possible implementation of the first aspect, or enable the apparatus to implement the method in the second aspect or any possible implementation of the second aspect.

A sixth aspect of embodiments of this application provides a first communication apparatus, including at least one logic circuit and an input/output interface, where
the input/output interface is configured to output a target signal; and
the logic circuit is configured to perform the method in the first aspect or any possible implementation of the first aspect.

A seventh aspect of embodiments of this application provides a second communication apparatus, including at least one logic circuit and an input/output interface, where
the input/output interface is configured to input a target signal; and
the logic circuit is configured to perform the method in the second aspect or any possible implementation of the second aspect.

An eighth aspect of embodiments of this application provides a computer-readable storage medium that stores one or more computer-executable instructions. When the computer-executable instructions are executed by a processor, the processor performs the method in the first aspect or any possible implementation of the first aspect.

A ninth aspect of embodiments of this application provides a computer-readable storage medium that stores one or more computer-executable instructions. When the computer-executable instructions are executed by a processor, the processor performs the method in the second aspect or any possible implementation of the second aspect.

Atenth aspect of embodiments of this application provides a computer program product (or referred to as a computer program) that stores one or more computers. When the computer program product is executed by a processor, the processor performs the method in the first aspect or any possible implementation of the first aspect.

An eleventh aspect of embodiments of this application provides a computer program product that stores one or more computers. When the computer program product is executed by the processor, the processor performs the method in the second aspect or any possible implementation of the second aspect.

A twelfth aspect of embodiments of this application provides a chip system. The chip system includes at least one processor, configured to support a first communication apparatus in implementing the function involved in the first aspect or any possible implementation of the first aspect.

In a possible design, the chip system may further include a memory. The memory is configured to store program instructions and data that are necessary for the first communication apparatus. The chip system may include a chip, or may include a chip and another discrete component. Optionally, the chip system further includes an interface circuit, and the interface circuit provides program instructions and/or data for the at least one processor.

A thirteenth aspect of embodiments of this application provides a chip system. The chip system includes at least one processor, configured to support a second communication apparatus in implementing the function involved in the second aspect or any possible implementation of the second aspect.

In a possible design, the chip system may further include a memory. The memory is configured to store program instructions and data that are necessary for the second communication apparatus. The chip system may include a chip, or may include a chip and another discrete component. Optionally, the chip system further includes an interface circuit, and the interface circuit provides program instructions and/or data for the at least one processor.

A fourteenth aspect of embodiments of this application provides a communication system. The communication system includes the first communication apparatus in the third aspect and the second communication apparatus in the fourth aspect, and/or the communication system includes the first communication apparatus in the fifth aspect, and/or the communication system includes the first communication apparatus in the sixth aspect and the second communication apparatus in the seventh aspect.

For the technical effects brought by any one of the design manners of the third aspect to the fourteenth aspect, refer to the technical effects brought by different design manners of the first aspect or the second aspect. Details are not described herein again.

### BRIEF DESCRIPTION OF DRAWINGS

FIG. 1 is a schematic diagram of an application scenario according to an embodiment of this application;
FIG. 2 is another schematic diagram of an application scenario according to an embodiment of this application;
FIG. 3 is a schematic diagram of a communication method according to an embodiment of this application;
FIG. 4-1 is a schematic diagram of a first communication apparatus according to an embodiment of this application;
FIG. 4-2 is a schematic diagram of an implementation effect of a communication method according to an embodiment of this application;
FIG. 4-3 is another schematic diagram of an implementation effect of a communication method according to an embodiment of this application;
FIG. 5-1 is another schematic diagram of a first communication apparatus according to an embodiment of this application;
FIG. 5-2 is another schematic diagram of a first communication apparatus according to an embodiment of this application;
FIG. 6-1 is a schematic diagram of a second communication apparatus according to an embodiment of this application;
FIG. 6-2 is another schematic diagram of a second communication apparatus according to an embodiment of this application;
FIG. 7 is another schematic diagram of a communication apparatus according to an embodiment of this application; and
FIG. 8 is another schematic diagram of a communication apparatus according to an embodiment of this application.

### DESCRIPTION OF EMBODIMENTS

The technical solutions of embodiments of this application will be described in the following with reference to the accompanying drawings. It is clear that embodiments to be described are merely a part rather than all embodiments of this application. All other embodiments obtained by a person of ordinary skill in the art based on embodiments of this application without creative efforts shall fall within the protection scope of this application.

First, some wordings in embodiments of this application are first explained below, to help a person skilled in the art have a better understanding.
(1) Terminal device: The terminal device may be a wireless terminal device that may receive scheduling and indication information of a network device. The wireless terminal device may be a device that provides voice and/or data connectivity for a user, a handheld device having a wireless connection function, or another processing device connected to a wireless modem.

The terminal device may communicate with one or more core networks or the internet through a radio access network (radio access network, RAN), and the terminal device may be a mobile terminal device such as a mobile phone (or referred to as a "cellular" phone, or a mobile phone (mobile phone)), a computer, and a data card, for example, may be portable, pocket-sized, hand-held, computer-built-in, or vehicle-mounted mobile devices that exchange language and/or data with the radio access network. For example, the terminal device may alternatively be a device such as a personal communications service (personal communications service, PCS) phone, a cordless phone, a session initiation protocol (SIP) phone, a wireless local loop (wireless local loop, WLL) station, a personal digital assistant (personal digital assistant, PDA), a tablet computer (Pad), and a computer with a wireless transceiver function. The wireless terminal device may also be referred to as a system, a subscriber unit (subscriber unit), a subscriber station (subscriber station), a mobile station (mobile station, MS), a remote station (remote station), an access point (access point, AP), a remote terminal (remote terminal) device, an access terminal (access terminal) device, a user terminal (user terminal) device, a user agent (user agent), a subscriber station (subscriber station, SS), customer premises equipment, (customer premises equipment, CPE), a terminal (terminal), user equipment (user equipment, UE), a mobile terminal (mobile terminal, MT), and the like. Alternatively, the terminal device may be a wearable device and a next-generation communication system, for example, a terminal device in a 5G communication system or a terminal device in a future evolved public land mobile network (public land mobile network, PLMN).

(2) Network device: The network device may be a device in a wireless network. For example, the network device may be a radio access network (radio access network, RAN) node (or a device) that enables the terminal device to access the wireless network, and may also be referred to as a base station. Currently, examples of some RAN devices are as follows: a new generation NodeB (generation NodeB, gNodeB), a transmission reception point (transmission reception point, TRP), an evolved NodeB (evolved NodeB, eNB), and a radio network controller (radio network controller, RNC), a NodeB (NodeB, NB), a base station controller (base station controller, BSC), a base transceiver station (base transceiver station, BTS), and a home NodeB (for example, home evolved NodeB, or home NodeB, HNB), a base band unit (base band unit, BBU), a wireless fidelity (wireless fidelity, Wi-Fi) access point (access point, AP), or the like in a 5G communication system. In addition, in a network structure, the network device may include a central unit (central unit, CU) node, a distributed unit (distributed unit, DU) node, or a RAN device that includes a CU node and a DU node.

The network device may send configuration information (for example, carried in a scheduling message and/or an indication message) to the terminal device. The terminal device further performs network configuration based on the configuration information, so that network configurations between the network device and the terminal device are aligned; or network configurations between the network device and the terminal device are aligned through a network configuration preset on the network device and a network configuration preset on the terminal device. Specifically, "alignment" means that when there is an interaction message between the network device and the terminal device, the network device and the terminal device have a consistent understanding of a carrier frequency for sending and receiving the interaction message, determining of a type of the interaction message, a meaning of field information carried in the interaction message, or another configuration of the interaction message.

In addition, in another possible case, the network device may be another apparatus that provides a wireless communication function for the terminal device. A specific technology and a specific device form used by the network device are not limited in embodiments of this application. For ease of description, this is not limited in embodiments of this application.

The network device may further include a core network device. The core network device includes, for example, an access and mobility management function (access and mobility management function, AMF), a user plane function (user plane function, UPF), a session management function (session management function, SMF), or the like.

In embodiments of this application, an apparatus configured to implement a function of the network device may be a network device, or may be an apparatus, for example, a chip system, that can support the network device in implementing the function. The apparatus may be installed in the network device. In the technical solutions provided in embodiments of this application, the technical solutions provided in embodiments of this application are described by using an example in which the apparatus configured to implement the function of the network device is the network device.

(3) The terms "system" and "network" may be used interchangeably in embodiments of this application. "At least one" means one or more, and "a plurality of" means two or more. The term "and/or" is an association relationship for describing associated objects and represents that three relationships may exist. For example, A and/or B may represent the following three cases: only A exists, both A and B exist, and only B exists, where A and B may be singular or plural. The character "/" generally indicates an "or" relationship between the associated objects. At least one of the following items (pieces) or a similar expression thereof refers to any combination of these items, including any combination of singular items (pieces) or plural items (pieces). For example, "at least one of A, B, and C" includes A, B, C, AB, AC, BC, or ABC. In addition, unless otherwise specified, ordinal numbers such as "first" and "second" in embodiments of this application are used to distinguish between a plurality of objects, and are not intended to limit a sequence, a time sequence, priorities, or importance of the plurality of objects.

This application may be applied to a long term evolution (long term evolution, LTE) system, a new radio (new radio, NR) system, or an NR vehicle to everything (NR vehicle to everything, NR V2X) system; and may alternatively be applied to a system in which LTE and 5G network in a hybrid manner; or a device-to-device (device-to-device, D2D) communication system, a machine-to-machine (machine to machine, M2M) communication system, an internet of things (Internet of Things, IoT), or an unmanned aerial vehicle communication system; or a communication system that supports a plurality of wireless technologies, for example, an LTE technology and an NR technology; or a non-terrestrial communication system, for example, a satellite communication system, a high-altitude communication platform, or the like. In addition, optionally, the communication system may also be applicable to a narrow band-internet of things (narrow band-internet of things, NB-IoT) system, an enhanced data rate for GSM evolution (enhanced data rate for GSM evolution, EDGE) system, and a wideband code division multiple access (wideband code division multiple access, WCDMA) system, a code division multiple access 2000 (code division multiple access, CDMA 2000) system, a time division-synchronization code division multiple access (time division-synchronization code division multiple access, TD-SCDMA) system, and a future-oriented communication technology; or another communication system. The communication system includes the network device and the terminal device. The network device is used as a configuration information sending entity, and the terminal device is used as a configuration information receiving entity. Specifically, an entity in the communication system sends configuration information to another entity, and sends data to the another entity, or receives data sent by the another entity; and the another entity receives the configuration information, and sends data to the configuration information sending entity, or receives data sent by the configuration information sending entity based on the configuration information. This application may be applied to a terminal device in a connected state or an active (active) state, or may be applied to a terminal device in a non-connected (inactive) state or an idle (idle) state.

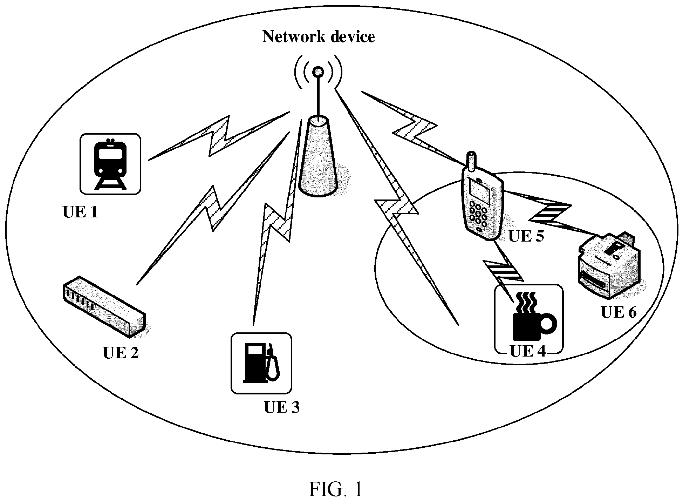

FIG. 1 is a schematic diagram of an application scenario according to an embodiment of this application. As shown in FIG. 1, a configuration information sending entity may be a network device, and a configuration information receiving entity may be UE 1 to LTE 6. In this case, a base station and the LTE 1 to the LTE 6 form a communication system. In the communication system, the UE 1 to the UE 6 may send uplink data to the network device. The network device needs to receive the uplink data sent by the UE 1 to the UE 6. In addition, the network device may send configuration information to the UE 1 to the UE 6.

As shown in FIG. 1, in a communication process, a sending device (or referred to as a transmit end or a transmit end device) may be the network device, and a receiving device (or referred to as a receiving end or a receiving end device) may be a terminal device; or the sending device may be a terminal device, and the receiving device may be the network device; or both a sending device and a receiving device may be the network devices; or both a sending device and a receiving device may be terminal devices.

The wireless communication process shown in FIG. 1 is used as an example. Communication manners of the sending device and the receiving device may be classified based on a distance between the sending device and the receiving device. For example, a communication manner whose communication distance is within hundreds of meters (or tens of meters) is referred to as short-range communication, and a communication manner whose communication distance is greater than hundreds of meters is referred to as long-range communication. Generally, in the longdistance communication, the communication distance between the sending device and the receiving device is long, and a frequency band signal of a low frequency may be used for communication. Because a wavelength of the frequency band signal of the low frequency is long, diffraction easily occurs in a transmission process. Therefore, the frequency band signal of the low frequency may propagate by bypassing a building, and can propagate a long distance. However, in the short-range communication, the communication distance between the sending device and the receiving device is short, and a frequency band signal of a high frequency may be used for communication. Because the frequency band signal of the high frequency can provide a wider system bandwidth, high-power transmission is easily implemented, to improve a throughput rate.

As a typical application scenario with a high requirement for a high throughput rate in the short-range communication, an extended reality (extended reality, XR) technology has developed rapidly in recent years. Compared with a conventional communication scenario, ultimate XR experience usually needs a peak throughput of 10 Gpbs (or even tens of Gpbs). Thanks to high-quality user experience of viewing and experiencing brought by a high peak throughput of the XR, the XR has a wide application prospect in fields such as entertainment, shopping, design, and medical treatment. Specifically, the XR includes a virtual reality (virtual reality, VR) technology, augmented reality (augmented reality, AR), mixed reality (mixed reality, MR), or the like.

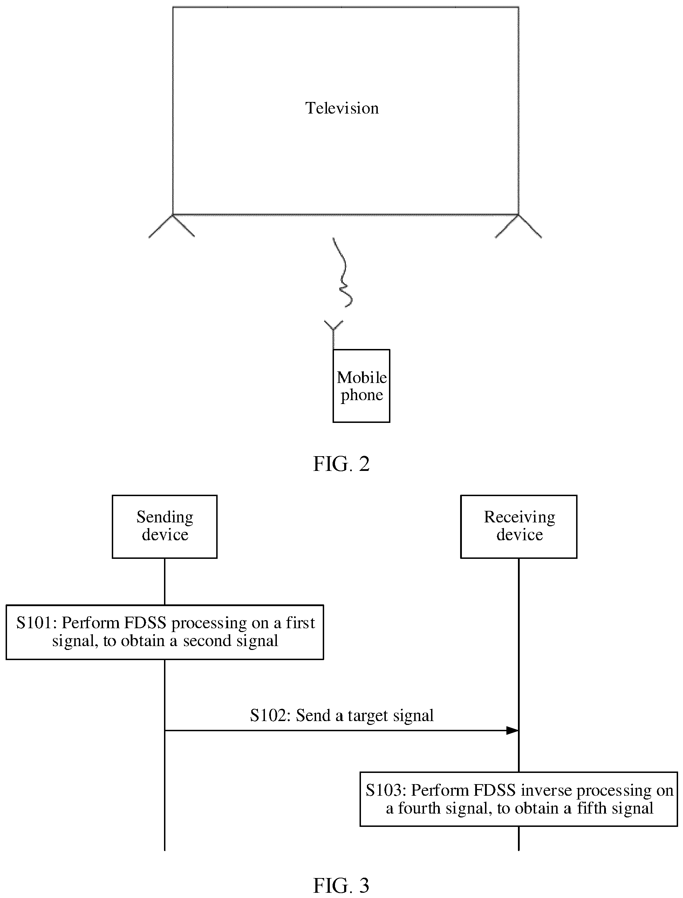

For example, FIG. 2 is a schematic diagram of an application scenario of XR according to an embodiment of this application. A plurality of different XR applications, such as a VR game, may be implemented by performing data exchange for wireless casting through two terminal devices, namely, a mobile phone and a television shown in FIG. 2. In a network structure of the XR application, an indoor short-range wireless transmission part becomes a bottleneck of the entire system due to reasons such as throughput limitation and unstable radio link quality.

In addition, a high throughput rate of the short-range communication may alternatively be applied to another application scenario, for example, data encoding and decoding in application software (application, APP) in a mobile phone, and large-capacity data transmission.

It is clear that when a throughput rate is improved, power consumption of the sending device and power consumption of the receiving device are easily increased. Therefore, how to implement a low-power short-range wireless communication technology is a technical problem to be urgently resolved.

Currently, in a short-range communication scenario, the sending device and the receiving device generally send and receive data according to a communication standard. The communication standard for short-range communication is a wireless personal area network (wireless personal area network, WPAN) in 802.11ad, 802.11ay, and 802.15.3.

In 802.11ad and 802.11ay, related designs of a media access control (medium access control, MAC) layer and a physical layer applied to a short-range communication system of an E-band (E-band) are specified. A physical layer of the E-band uses an orthogonal frequency division multiplexing (orthogonal frequency division multiplexing, OFDM) waveform or a single carrier (single carrier, SC) waveform. The SC waveform has a low PAPR, and a power amplifier (power amplifier, PA) with a low dynamic range may be used, to achieve low costs and low power consumption. In terms of channel coding, 802.11ad and 802.11ay use an LDPC code with a fixed code length (for example, a code length in 11ay is 1344) and a maximum code rate of 7/8. However, the SC waveform and the OFDM waveform in the 802.11ad standard and the 802.11ay standard need to be generated by using all different sending links. The SC waveform is sent after bandlimited filtering shaping is performed on a single-carrier signal by using a shaping filter. The OFDM waveform is sent by using a plurality of orthogonal subcarriers with IFFT processing performance. Therefore, to support generation of the two types of waveforms, the sending device needs to configure two sets of signal generation links. In addition, because the LDPC code is used, a maximum code rate is limited to 7/8 to ensure performance of the LDPC code.

In 802.15.3, a version 3c-2009 also provides a physical layer design applied to the E-band, and also uses the OFDM waveform or the SC waveform, and the LDPC code or a CC code. However, 802.15.3 is mainly used for communication between wearable devices, and a designed communication distance is less than 1 meter. However, in a typical XR application scenario (such as a living room or a conference room), a communication distance usually needs to be several meters. Therefore, 802.15.3 cannot meet the requirement.

It can be learned from the foregoing content that in the current short-range communication scenario, at least the following problems exist: The sending device in the short-range communication scenario needs to have a sending and receiving link of two different signals such as an SC signal and an OFDM signal. As a result, costs and power consumption of the sending device are high. In addition, setting that supports only the highest code rate of 7/8 has a large limitation on a throughput rate of the communication system, and cannot meet a communication requirement of an application such as XR.

Therefore, embodiments of this application provide a communication method and apparatus, to reduce a PAPR of a signal sent by a sending device by using an FDSS waveform processing manner, and reduce decoding power consumption of a receiving device by using a coding manner of polar encoding. This improves communication energy efficiency.

FIG. 3 is a schematic diagram of a communication method according to an embodiment of this application. The method includes the following steps.

S101: A sending device performs FDSS processing on a first signal, to obtain a second signal.

In this embodiment, a first communication apparatus used as the sending device performs FDSS processing on the first signal in step S101, to obtain a spread second signal, where the first signal is a signal obtained by performing polar encoding based on a modulation and coding scheme.

Specifically, a communication scenario of the first communication apparatus used as the sending device and a second communication apparatus used as a receiving device below may be short-range communication. Operating frequency bands of different communication apparatuses in a short-range communication scenario are between 30 GHz and 300 GHz, and the frequency band may also be referred to as a millimeter wave frequency band, or an extremely high frequency (extremely high frequency, EHF) frequency band. Compared with a conventional communication scenario in which a low frequency band is used, in the short-range communication, a communication distance between the sending device and the receiving device is short, and a frequency band signal of a high frequency may be used for communication. Because a frequency band of the high frequency may provide a wider system bandwidth, high-power transmission is easily implemented, to improve a throughput rate and meet a communication requirement of a high throughput rate.

In a possible implementation, in step S101, a process in which the first communication apparatus used as the sending device performs frequency domain spectrum shaping FDSS processing on the first signal, to obtain the second signal may specifically include: The first communication apparatus first performs discrete fourier transform (discrete fourier transform, DFT) processing on the first signal, to obtain a third signal; and then, the first communication apparatus performs filtering processing on the third signal, to obtain the second signal. Specifically, the DFT processing is for performing transform processing on a time domain signal to obtain a frequency domain signal. In a process of performing FDSS processing on the first signal, the sending device may first perform DFT processing on the first signal to obtain the third signal, and then perform filtering processing on the third signal, to obtain the spread second signal.

It should be noted that as a special implementation form of the DFT, fast fourier transform (fast fourier transform, FFT) is a fast algorithm for implementing the DFT. Therefore, the foregoing DFT processing process may also be implemented through an FFT processing process.

In a possible implementation, a sampling rate of a baseband signal of the first communication apparatus used as the sending device is a positive integer multiple of 30.72 megahertz MHz. Specifically, to support normal operation of the first communication apparatus in another communication system (a communication system, such as LTE or another communication system, limiting a sampling rate of a baseband signal to 30.72 MHz), the sampling rate of the baseband signal of the first communication apparatus may be set to the positive integer multiple of 30.72 MHz, to improve compatibility of the first communication apparatus in different communication systems, and flexible configuration may also be performed based on a system bandwidth of the communication system, to further improve communication energy efficiency.

It should be noted that the sampling rate of the baseband signal of the first communication apparatus is the positive integer multiple of 30.72 MHz. For example, when the system bandwidth is 2.5 GHz, a value of the positive integer multiple may be 8, namely, 2.4576 GHz; or when the system bandwidth is 5.0 GHz, a value of the positive integer multiple may be 16, namely, 4.9152 GHz; or when the system bandwidth is 7.5 GHz, a value of the positive integer multiple may be 24, namely, 7.3728 GHz; or when the system bandwidth is 10.0 GHz, a value of the positive integer multiple may be 32, namely, 9.8304 GHz; or a value of the positive integer multiple is another value, and is not limited herein. In other words, different multiples of the positive integer multiple of 30.72 MHz are selected in different system bandwidths, so that spectrum utilization of a communication system in which the first communication apparatus is in is improved on a premise that compatibility of the first communication apparatus in different communication systems is improved.

Optionally, to support communication of the first communication apparatus in another communication system, the sampling rate of the baseband signal of the first communication apparatus may alternatively use another value, for example, an integer multiple of 3.84 MHz, an integer multiple of 15.36 MHz, or another value. This is not limited herein.

In a possible implementation, the first signal is a signal obtained by performing polar encoding based on the modulation and coding scheme. In other words, the sending device performs polar encoding on to-be-sent bit information based on the modulation and coding scheme to obtain the first signal. Specifically, the modulation and coding scheme may include a plurality of pieces of configuration information. In addition, any piece of configuration information includes at least a code rate. When a code rate of the modulation and coding scheme includes 15/16, compared with an implementation of another code rate (for example, 1/2, 3/4, 7/8, or the like) commonly used in a scenario in which an operating frequency band is between 30 gigahertz GHz and 300 GHz, a high throughput rate may be achieved by using a high code rate, to meet a requirement for a high throughput rate in a short-range wireless communication technology.

Optionally, the code rate of the modulation and coding scheme may further include one or more of 1/2, 3/4, 5/8, 7/8, and 13/16.

It should be noted that the modulation and coding scheme mentioned in this embodiment and subsequent embodiments may be implemented in a plurality of different forms, such as a text, a table, a schematic diagram, and the like. This is not limited herein. For example, when the modulation and coding scheme is implemented through the table, the modulation and coding scheme may be a modulation and coding scheme (modulation and coding scheme, MCS) table.

In a possible implementation, the first signal is a signal obtained by performing polar encoding based on the modulation and coding scheme. In other words, the sending device performs polar encoding on to-be-sent bit information based on the modulation and coding scheme to obtain the first signal. Specifically, the modulation and coding scheme may include a plurality of pieces of configuration information. In addition, any piece of configuration information includes at least a modulation manner. When the modulation manner of the modulation and coding scheme includes 8 QAM, compared with an implementation of another modulation manner (for example, a large span from low spectral efficiency corresponding to quadrature phase shift keying (Quadrature Phase Shift Keying, QPSK) to high spectral efficiency corresponding to 16-order QAM) commonly used in a scenario in which an operating frequency band is between 30 gigahertz GHz and 300 GHz, by using the modulation manner of the 8 QAM, spectral efficiency of the first communication apparatus may smoothly transition from a modulation manner of the low spectral efficiency to a modulation manner of the high spectral efficiency. This improves throughput performance of the communication system.

Optionally, the code rate of the modulation and coding scheme may further include one or more of binary phase shift keying (binary phase shift keying, BPSK), QPSK, and 16 QAM.

S 102: The sending device sends a target signal to the receiving device.

In this embodiment, after obtaining the second signal in step S101, the sending device sends the target signal to the receiving device in step S102, where the target signal is a signal obtained based on the second signal. Correspondingly, in step S102, the receiving device obtains the target signal from the sending device in a data receiving manner.

In a possible implementation, in step S101, the third signal obtained by performing DFT processing on the first signal may be a signal obtained by performing processing based on a first DFT point quantity; and in step S102, the target signal is a signal obtained by performing inverse discrete fourier transform (inverse discrete fourier transform, IDFT) processing on the second signal based on a second DFT point quantity. The IDFT processing is for performing transform processing on the frequency domain signal to obtain the time domain signal, and the third signal may be specifically a signal obtained by performing DFT processing on the first signal based on the first DFT point quantity. The target signal may be a signal obtained by performing IDFT processing on the second signal based on the second DFT point quantity. When the first DFT point quantity is less than a second IDFT point quantity, spectrum spreading may be performed on the second signal, to implement FDSS processing to obtain a target signal with a lower PAPR.

It should be noted that the target signal is a signal obtained by performing, at least based on the second DFT point quantity, inverse fourier transform IDFT processing on the second signal. Another processing process, for example, cyclic prefix (cyclic prefix, CP) addition, parallel/serial (P/S) conversion, or another processing process may alternatively be performed, which is not limited herein. In addition, as a special implementation manner of the IDFT, inverse fast fourier transform (inverse fast fourier transform, IFFT) is a fast algorithm for implementing the IDFT, and the foregoing IDFT processing process may also be implemented through an IFFT processing process.

Specifically, there may be a mathematical limitation relationship between the first DFT point quantity used to perform DFT processing on the first signal and the second point quantity used to perform IDFT processing on the second signal. For example, a numerical ratio of the first DFT point quantity to the second DFT point quantity is 2 to 3. Alternatively, a numerical ratio of the first DFT point quantity to the second DFT point quantity is 4 to 5, or another mathematical relationship is used. This is not specifically limited herein.

When the numerical ratio of the first DFT point quantity to the second DFT point quantity is 2 to 3, it can be learned that a maximum alpha value of a filter (filter) used to implement filtering processing may be 0.5. The alpha value of the filter is used to limit a design of the filter. For example, when a root-raised cosine filter is used, the alpha value is a roll-off factor of the root-raised cosine filter. A design of a filter required by the sending device may be conveniently guided based on the alpha value. Optionally, when the numerical ratio of the first DFT point quantity to the second DFT point quantity is 2 to 3, a value of the first DFT point quantity may be 512, and a value of the second DFT point quantity may be 768; or a value of the first DFT point quantity may be 1024, and a value of the second DFT point quantity may be 1536; or another value combination, which is not limited herein.

Similarly, when the numerical ratio of the first DFT point quantity to the second DFT point quantity is 4 to 5, it can be learned that a maximum alpha value of a filter (filter) used to implement filtering processing may be 0.25. Optionally, when the numerical ratio of the first DFT point quantity to the second DFT point quantity is 4 to 5, a value of the first DFT point quantity may be 512, and a value of the second DFT point quantity may be 640; or a value of the first DFT point quantity may be 1024, and a value of the second DFT point quantity may be 1280; or another value combination, which is not limited herein.

In a possible implementation, a subcarrier spacing of the target signal sent by the sending device in step S102 is a positive integer multiple of 1.6 MHz or a positive integer multiple of 1.92 MHz. When sending the target signal, the first communication apparatus used as the sending device may flexibly select a subcarrier spacing based on different communication scenarios. For example, when a system phase noise is large, a large subcarrier spacing may be used to improve a capability of resisting the phase noise; and when multipath interference is strong, a small subcarrier spacing may be used to increase a length of a CP. This reduces intersymbol interference and intercarrier interference, and improves communication energy efficiency.

In a possible implementation, the target signal sent by the sending device in step S102 further includes a cyclic prefix CP, and a time length of the CP includes at least one of the following: 26.04 nanoseconds ns, 104.16 ns, 52.08 ns, and 208.32 ns.

When sending the target signal, the first communication apparatus used as the sending device may flexibly select the time length of the CP based on different communication scenarios. For example, when an amount of data service transmission is large, a small length of the CP may be used to increase a data bandwidth part; and when multipath interference is strong, a large length of the CP may be used. This reduces intersymbol interference and intercarrier interference, and improves communication energy efficiency.

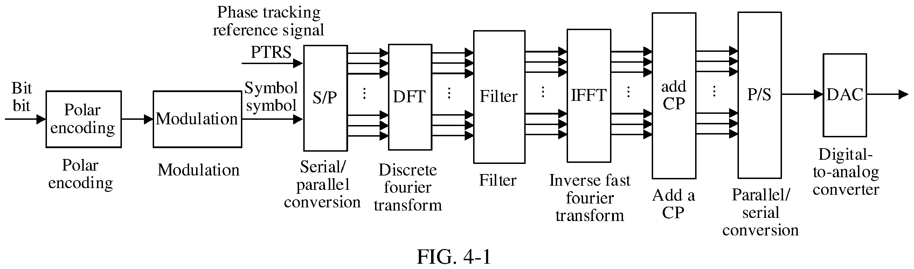

For example, FIG. 4-1 is used as an implementation example of the sending device. Specifically, the sending device may perform processing on bit information through modules shown in FIG. 4-1, to obtain a sending signal used for wireless transmission. It should be noted that the modules shown in FIG. 4-1 may be implemented through hardware in the sending device, or may be implemented through software simulation. This is not limited herein. In addition, an implementation process of step S101 and an implementation process of step S102 may be implemented based on the sending device shown in FIG. 4-1. It should be noted that in an implementation process of the solution, the modules included in the sending device shown in FIG. 4-1 may be added or deleted based on a conventional technology in the communication field. The sending device shown in FIG. 4-1 is merely an example of implementation.

The following describes a processing procedure in FIG. 4-1 by using a specific example. Specifically, the processing procedure may include the following steps.

Step 1: A polar encoding (Polar encoding) module processes to-be-sent bit (bit) information, to obtain an encoded signal, and the encoded signal is input into a modulation (Modulation) module.

Step 2: The modulation module processes the encoded signal, to obtain a modulated time domain symbol (symbol), and the modulated time domain symbol is input into a serial/parallel (S/P) conversion module.

Step 3: The S/P module performs processing on the modulated time domain symbol and a phase tracking reference signal (phase tracking reference signal, PTRS) to obtain a first signal corresponding to step S101.

Step 4: After using the first signal as an input of a DFT module, to obtain a third signal, use the third signal as an input of a filter (Filter) module, to obtain a second signal, to implement the FDSS processing process in step S101. Through the FDSS processing, a PAPR of a signal finally generated by a transmitter can be lower, and costs and power consumption of a PA can be reduced.

Step 5: Use the second signal as an input of an IFFT module, to obtain an output result, and then sequentially perform processing by an add CP (add CP) module, a parallel/serial (P/S) conversion module, and a digital-to-analog converter (digital-to-analog converter, DAC) module, to obtain the target signal. The target signal is sent corresponding to step S102, so that the receiving device obtains the target signal.

Specifically, it can be learned from the implementation process of step 1 to step 5 that compared with an implementation process of using an LDPC code as channel coding, an extremely high code rate cannot be implemented generally due to a limitation of construction of the LDPC code; and in addition, decoding power consumption of the LDPC code is high, and the LDPC code is not suitable for a low power consumption system. Therefore, the polar code is used as a channel coding scheme to obtain the first signal, and setting including at least a code rate of 15/16 is used. Therefore, compared with an LDPC code decoder, a decoder using the polar code may complete decoding with lower power consumption, and use of the extremely high code rate of 15/16 improves peak throughput of a system. In addition, through the FDSS processing, a PAPR of a signal finally generated and sent by the sending device may be lower, and costs and power consumption of the PA can be reduced.

In addition, in a plurality of possible implementations of step 101 and step 102, a plurality of possible designs of a numerology (numerology) of the sending device are provided, specifically including a baseband sampling rate of the sending device, a DFT point quantity, a subcarrier spacing of a sent target signal, a time length of a CP used by the sent target signal, an alpha value of a filter, and the like. Further, it can be learned from the description of step S101 that the first signal is a signal obtained by performing polar encoding based on the modulation and coding scheme. In other words, the first signal may be obtained through the processing process of step 1 to step 3. Specifically, in an encoding process of step 1, as mentioned above, the sending device may perform a polar encoding process in a polar encoding (Polar encoding) module based on an MCS table.

The following describes a plurality of possible designs of the related numerology and the MCS table in a form of a table. It should be noted that the following plurality of tables (Table 1 to Table 10) are merely implementation examples. In a solution implementation process, any quantity of tables in the plurality of tables may be combined to obtain a new table, or any one of the plurality of tables may be split to obtain a new table, or any quantity of tables in the plurality of tables are split and combined to obtain a new table, or data in the plurality of tables is represented in another form, for example, a text or a picture. This is not specifically limited herein.

Table 1 shows a possible numerology design in the sending device.

**Table 1**

| Parameter name | Value |
|---|---|
| Baseband sampling rate | 2.4576 GHz |
| System bandwidth | 2.5 GHz |
| IFFT point quantity | 768 |
| Subcarrier spacing | 3.2 MHz |
| Quantity of data subcarriers | 480 |
| Total quantity of subcarriers | 512 |
| Quantity of PTRS subcarriers | 32 |
| Sampling interval | 0.407 ns |
| Length of a data symbol | 312.5 ns |
| CP point quantity | 64/256 |
| Length of a CP | 26.04/104.16 ns |
| Alpha value of a filter | <=0.5 |

Table 1 shows a possible numerology design that takes into account special requirements of a plurality of system and hardware implementations:
1. A baseband sampling rate of 2.4576 GHz is a common hardware device parameter;
2. Values of 512 DFT points and values of 768 IFFT points meet an implementation requirement of low complexity hardware of DFT/IFFT;
3. A subcarrier spacing of 3.2 MHz is large, which may resist a harmful impact of high-frequency system phase noise to some extent; and
4. The alpha value of the filter is used to limit a design of the filter. For example, when a root-raised cosine filter is used, alpha is a roll-off factor of the root-raised cosine filter, and a required filter may be conveniently designed based on a value less than 0.5.

It can be learned from Table 1 that each symbol of the system includes 480 data subcarriers. When a code length of channel coding is designed to be an integer multiple of 480, joint demodulation and decoding processing may be performed on an integer quantity of symbols, to improve hardware processing efficiency of a receiver. Therefore, in this scheme, a polar code whose code length is 960 is used, and rate matching may be performed on a mother code of the polar code whose length is 1024 to obtain a code word of the polar code whose code length is 960. There may be six code rates including {1/2, 5/8, 3/4, 13/16, 7/8, 15/16}. A possible design of an MCS table is shown in Table 2.

**Table 2**

| MCS index | Efficiency | Code rate | Efficiency |
|---|---|---|---|
| 0 | Reserved | | |
| 1 | BPSK | 1/2 | 0.5 |
| 2 | BPSK | 3/4 | 0.75 |
| 3 | BPSK | 13/16 | 0.8125 |
| 4 | BPSK | 7/8 | 0.875 |
| 5 | BPSK | 15/16 | 0.9375 |
| 6 | QPSK | 1/2 | 1 |
| 7 | QPSK | 3/4 | 1.5 |
| 8 | QPSK | 13/16 | 1.625 |
| 9 | QPSK | 7/8 | 1.75 |
| 10 | QPSK | 15/16 | 1.875 |
| 11 | 16 QAM | 3/4 | 3 |
| 12 | 16 QAM | 13/16 | 3.25 |
| 13 | 16 QAM | 7/8 | 3.5 |
| 14 | 16 QAM | 15/16 | 3.75 |
| 15 | 64 QAM | 3/4 | 4.5 |

**Table 3**

| MCS index | Modulation | Code rate | Efficiency | Throughput (Gbps) | | | |
|---|---|---|---|---|---|---|---|
| | | | | Single stream | | Dual streams | |
| | | | | Short CP | Long CP | Short CP | Long CP |
| 0 | Reserved | | | | | | |
| 1 | BPSK | 1/2 | 0.5 | 0.709 | 0.576 | 1.418 | 1.152 |
| 2 | BPSK | 3/4 | 0.75 | 1.063 | 0.864 | 2.127 | 1.728 |
| 3 | BPSK | 13/16 | 0.8125 | 1.152 | 0.936 | 2.304 | 1.872 |
| 4 | BPSK | 7/8 | 0.875 | 1.241 | 1.008 | 2.481 | 2.016 |
| 5 | BPSK | 15/16 | 0.9375 | 1.329 | 1.080 | 2.658 | 2.160 |
| 6 | QPSK | 1/2 | 1 | 1.418 | 1.152 | 2.836 | 2.304 |
| 7 | QPSK | 3/4 | 1.5 | 2.127 | 1.728 | 4.254 | 3.456 |
| 8 | QPSK | 13/16 | 1.625 | 2.304 | 1.872 | 4.608 | 3.744 |
| 9 | QPSK | 7/8 | 1.75 | 2.481 | 2.016 | 4.962 | 4.032 |
| 10 | QPSK | 15/16 | 1.875 | 2.658 | 2.160 | 5.317 | 4.320 |
| 11 | 16 QAM | 3/4 | 3 | 4.254 | 3.456 | 8.507 | 6.912 |
| 12 | 16 QAM | 13/16 | 3.25 | 4.608 | 3.744 | 9.216 | 7.488 |
| 13 | 16 QAM | 7/8 | 3.5 | 4.962 | 4.032 | 9.925 | 8.064 |
| 14 | 16 QAM | 15/16 | 3.75 | 5.317 | 4.320 | 10.634 | 8.640 |
| 15 | 64 QAM | 3/4 | 4.5 | 6.380 | 5.184 | 12.761 | 10.368 |

In the numerology design provided in embodiments shown in Table 1 to Table 3, an alpha value of a filter may reach 0.5. Therefore, when a system bandwidth is 2.5 GHz, an actual data bandwidth part is only 1.64 GHz (namely, 512*3.2 MHz), and spectral efficiency of the system is low. Therefore, this embodiment provides a numerology design with high system spectral efficiency. As shown in Table 4, a baseband sampling rate, namely, 2.4576 GHz, that is commonly used is still used. A maximum alpha value of the filter may reach 0.25, and the data bandwidth part is 1.966 GHz (namely, 512*3.84 MHz).

**Table 4**

| Parameter name | Value |
|---|---|
| Baseband sampling rate | 2.4576 GHz |
| System bandwidth | 2.5 GHz |
| IFFT point quantity | 640 |
| Subcarrier spacing | 3.84 MHz |
| Quantity of data subcarriers | 480 |
| Total quantity of subcarriers | 512 |
| Quantity of PTRS subcarriers | 32 |
| Sampling interval | 0.407 ns |
| Length of a data symbol | 260.4 ns |
| CP point quantity | 64/256 |
| Length of a CP | 26.04/104.16 ns |
| Alpha value of a filter | <=0.25 |

Similarly, when the MCS design shown in Table 2 and the numerology shown in Table 4 are used, throughput of the system is shown in Table 5. In other words, dual-stream transmission is performed at a system bandwidth of 2.5 GHz. Both MCS 11 to 15 used in a short CP and MCS 15 used in a long CP may reach the system throughput (to be specific, peak throughput required for ultimate XR experience) higher than 10 Gbps.

**Table 5**

| MCS index | Modulation | Code rate | Efficiency | Throughput (Gbps) | | | |
|---|---|---|---|---|---|---|---|
| | | | | Single stream | | Dual streams | |
| | | | | Short CP | Long CP | Short CP | Long CP |
| 0 | Reserved | | | | | | |
| 1 | BPSK | 1/2 | 0.5 | 0.838 | 0.658 | 1.676 | 1.317 |
| 2 | BPSK | ¾ | 0.75 | 1.257 | 0.987 | 2.513 | 1.975 |
| 3 | BPSK | 13/16 | 0.8125 | 1.361 | 1.070 | 2.723 | 2.139 |
| 4 | BPSK | 7/8 | 0.875 | 1.466 | 1.152 | 2.932 | 2.304 |
| 5 | BPSK | 15/16 | 0.9375 | 1.571 | 1.234 | 3.142 | 2.468 |
| 6 | QPSK | 1/2 | 1 | 1.676 | 1.317 | 3.351 | 2.633 |
| 7 | QPSK | 3/4 | 1.5 | 2.513 | 1.975 | 5.027 | 3.950 |
| 8 | QPSK | 13/16 | 1.625 | 2.723 | 2.139 | 5.446 | 4.279 |
| 9 | QPSK | 7/8 | 1.75 | 2.932 | 2.304 | 5.865 | 4.608 |
| 10 | QPSK | 15/16 | 1.875 | 3.142 | 2.468 | 6.284 | 4.937 |
| 11 | 16 QAM | 3/4 | 3 | 5.027 | 3.950 | 10.054 | 7.899 |
| 12 | 16 QAM | 13/16 | 3.25 | 5.446 | 4.279 | 10.892 | 8.557 |
| 13 | 16 QAM | 7/8 | 3.5 | 5.865 | 4.608 | 11.729 | 9.216 |
| 14 | 16 QAM | 15/16 | 3.75 | 6.284 | 4.937 | 12.567 | 9.874 |
| 15 | 64 QAM | 3/4 | 4.5 | 7.540 | 5.924 | 15.081 | 11.849 |

Considering that the wireless communication system in this application is mainly used in a high throughput scenario, and to obtain a finer MCS adjustment granularity, this embodiment provides another possible design of the MCS table, as shown in Table 6. Compared with Table 2, an implementation example in Table 6 has the following differences:
1. Reduce BPSK low-bit-rate entries because a high throughput system may not need these MCS schemes whose efficiency is low.
2. Add an entry of 8 QAM to cause efficiency to transition between 1.875 and 3 in a finer manner.

**Table 6**

| MCS index | Modulation | Code rate | Efficiency |
|---|---|---|---|
| 0 | Reserved | | |
| 1 | BPSK | 15/16 | 0.9375 |
| 2 | QPSK | 5/8 | 1.25 |
| 3 | QPSK | 3/4 | 1.5 |
| 4 | QPSK | 13/16 | 1.625 |
| 5 | QPSK | 7/8 | 1.75 |
| 6 | QPSK | 15/16 | 1.875 |
| 7 | 8 QAM | 3/4 | 2.25 |
| 8 | 8 QAM | 13/16 | 2.4375 |
| 9 | 8 QAM | 7/8 | 2.625 |
| 10 | 8 QAM | 15/16 | 2.8125 |
| 11 | 16 QAM | 3/4 | 3 |
| 12 | 16 QAM | 13/16 | 3.25 |
| 13 | 16 QAM | 7/8 | 3.5 |
| 14 | 16 QAM | 15/16 | 3.75 |
| 15 | 64 QAM | 3/4 | 4.5 |

To support services with different rate requirements, the numerology described in this embodiment may be selected based on an actual system bandwidth. A design principle of the numerology corresponding to different system bandwidths is to keep a length of a symbol unchanged, and increase or decrease a quantity of subcarriers. Table 7 and Table 8 respectively show designs corresponding to the numerology in Table 1 and Table 4 under system bandwidths of 2.5 GHz, 5 GHz, 7.5 GHz, and 10 GHz.

**Table 7**

| | | | | |
|---|---|---|---|---|
| System bandwidth (GHz) | 2.5 | 5 | 7.5 | 10 |
| Sampling rate (GHz) | 2.4576 | 4.9152 | 7.3728 | 9.8304 |
| Subcarrier spacing (MHz) | 3.2 | 3.2 | 3.2 | 3.2 |
| Sampling interval (ns) | 0.407 | 0.203 | 0.136 | 0.102 |
| IFFT point quantity | 768 | 1536 | 2304 | 3072 |
| CP point quantity | 64/256 | 128/512 | 192/768 | 256/1024 |
| Length of a data symbol (ns) | 260.4 | 260.4 | 260.4 | 260.4 |
| Length of a CP (ns) | 26.04/104.16 | 26.04/104.16 | 26.04/104.16 | 26.04/104.16 |
| Quantity of data subcarriers | 480 | 960 | 1440 | 1920 |
| Quantity of PTRS subcarriers | 32 | 64 | 96 | 128 |
| Data bandwidth part (GHz) | 1.64 | 3.28 | 4.92 | 6.56 |

**Table 8**

| | | | | |
|---|---|---|---|---|
| System bandwidth (GHz) | 2.5 | 5 | 7.5 | 10 |
| Sampling rate (GHz) | 2.4576 | 4.9152 | 7.3728 | 9.8304 |
| Subcarrier spacing (MHz) | 3.84 | 3.84 | 3.84 | 3.84 |
| Sampling interval (ns) | 0.407 | 0.203 | 0.136 | 0.102 |
| IFFT point quantity | 640 | 1280 | 1920 | 2560 |
| CP point quantity | 64/256 | 128/512 | 192/768 | 256/1024 |
| Length of a data symbol (ns) | 260.4 | 260.4 | 260.4 | 260.4 |
| Length of a CP (ns) | 26.04/104.16 | 26.04/104.16 | 26.04/104.16 | 26.04/104.16 |
| Quantity of data subcarriers | 480 | 960 | 1440 | 1920 |
| Quantity of PTRS subcarriers | 32 | 64 | 96 | 128 |
| Data bandwidth part (GHz) | 1.966 | 3.932 | 5.898 | 7.864 |

It can be learned from Table 7 and Table 8 that under different system bandwidths, the length of the data symbol and the length of the CP are fixed.

In the numerology provided in embodiments shown in Table 1 to Table 8, the length of the CP has two configurations: 26.04 ns and 104.16 ns. When a channel delay spread in an actual application scenario exceeds 104.16 ns, because the length of the CP is insufficient, intersymbol interference and intercarrier interference are introduced, causing a decrease in system performance. In this case, the subcarrier spacing may be adjusted, so that the length of the CP becomes longer, to resist a longer channel delay spread. Specific implementations are shown in Table 9 and Table 10.

**Table 9**

| | |
|---|---|
| System bandwidth (GHz) | 2.5 |
| Sampling rate (GHz) | 2.4576 |
| Subcarrier spacing (MHz) | 1.6 |
| Sampling interval (ns) | 0.407 |
| IFFT point quantity | 1536 |
| CP point quantity | 128/512 |
| Length of a data symbol (ns) | 520.8 |
| Length of a CP (ns) | 52.08/208.32 |
| Quantity of data subcarriers | 960 |
| Quantity of PTRS subcarriers | 64 |
| Data bandwidth part (GHz) | 1.64 |

**Table 10**

| | |
|---|---|
| System bandwidth (GHz) | 2.5 |
| Sampling rate (GHz) | 2.4576 |
| Subcarrier spacing (MHz) | 1.92 |
| Sampling interval (ns) | 0.407 |
| IFFT point quantity | 1280 |
| CP point quantity | 128/512 |
| Length of a data symbol (ns) | 520.8 |
| Length of a CP (ns) | 52.08/208.32 |
| Quantity of data subcarriers | 960 |
| Quantity of PTRS subcarriers | 64 |
| Data bandwidth part (GHz) | 1.966 |

It can be learned from Table 9 and Table 10 that by reducing the subcarrier spacing, the length of the CP may be extended to 52.08 ns and 208.32 ns, and therefore a longer channel delay spread may be resisted. Considering impact of a phase shift in a high-frequency system on a system, a subcarrier spacing generally cannot be too small. Therefore, a preferred scheme is to use a subcarrier spacing of a multiple of 1.6 MHz or a multiple of 1.92 MHz, to be specific, the subcarrier spacing is not less than 1.6 MHz or 1.92 MHz. The maximum resistible channel delay spread is 52.08 ns (a short CP) and 208.32 ns (a long CP).

Based on the plurality of possible implementation schemes in Table 1 to Table 10, a plurality of numerology design parameter tables are provided. In different designs of the numerology, flexible configuration is performed based on a principle that a symbol length is unchanged, and a corresponding parameter configuration table is obtained. In addition, to meet different delay spread requirements, a subcarrier spacing in a plurality of numerology design parameter tables is adjusted, and a subcarrier spacing of a multiple of 1.6 MHz or 1.92 MHz is used. Further, based on a channel coding scheme of the polar code and the design of the MCS table with a maximum code rate of 15/16, 8 QAM modulation is used, and transition smoothness of MCS entry efficiency is improved.

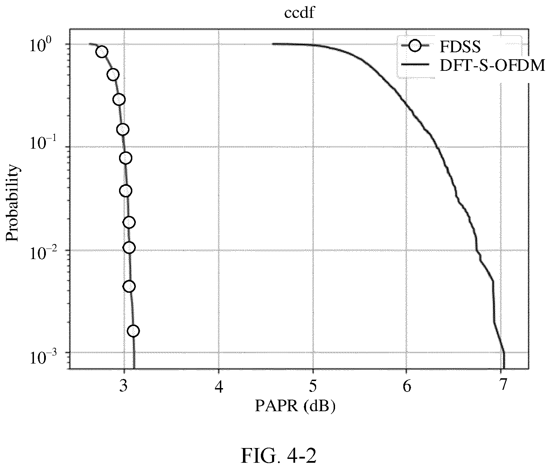

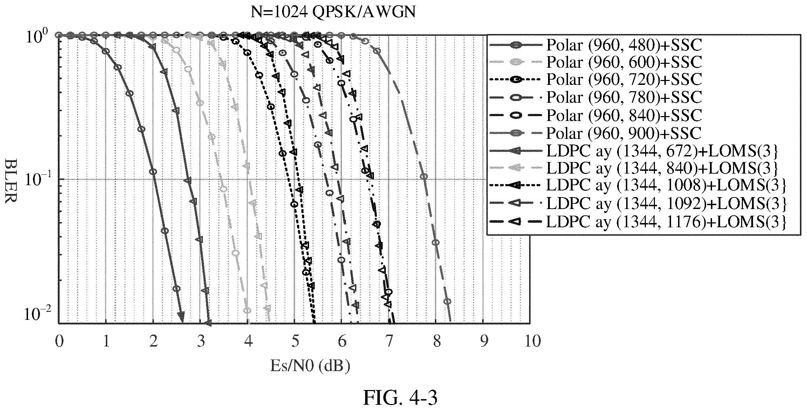

In an implementation example, based on the implementation schemes in Table 1 to Table 10, schematic diagrams of simulation effect of the two signals in FIG. 4-2 and FIG. 4-3 are provided. Refer to FIG. 4-2. An example of PAPR performance based on a complementary cumulative distribution function (complementary cumulative distribution function, ccdf) is shown. In FIG. 4-2, a value of a horizontal coordinate is the PAPR, and a unit is dB; a value of a vertical coordinate is probability (probability); and it is clear that under the same value of the vertical coordinate, the PAPR of the FDSS is lower than that of the conventional scheme using discrete fourier transform-spread-orthogonal frequency division multiplexing (discrete Fourier transform-spread-orthogonal frequency division multiplexing, DFT-S-OFDM). FIG. 4-3 is an example of block error rate performance in an additive white gaussian noise (additive white gaussian noise, AWGN) channel scenario in which a modulation manner is QPSK. In FIG. 4-3, the value of the horizontal coordinate is a symbol signal-to-noise ratio (Es/N0), and a unit is dB; a value of a vertical coordinate is a block error ratio (block error ratio, BLER); a code length of the polar code is 960, quantities of information bits are {480, 600, 720, 780, 840, 900}, to be specific, corresponding code rates are {1/2, 5/8, 3/4, 13/16, 7/8, 15/16}, and a simplified successive cancellation (simplified successive cancellation, SSC) decoder is used; and the LDPC uses an LDPC code design of the 802.11ay standard, a code length is 1344, and quantities of information bits are {672, 840, 1008, 1092, 1176} respectively, to be specific, corresponding code rates are {1/2, 5/8, 3/4, 13/16, 7/8}, and decoding is performed by using a layered offset min-sum (layered offset min-sum, LOMS) decoder three iterations (LOMS(3)). It can be learned that to achieve a same block error rate, a signal-to-noise ratio required by the polar code is lower than a signal-to-noise ratio required by the LDPC code, to be specific, the polar code has better block error rate performance.

Specifically, based on the foregoing technical solution, the following technical effects may be obtained: The PAPR of the sent signal is reduced by using the FDSS waveform, and costs and power consumption of the transmitter can be reduced; a variable system bandwidth supports a plurality of services at different rates; a variable subcarrier spacing may resist channel delay spreads of different lengths; the polar code is used as the channel coding scheme, to reduce decoding power consumption and improve system performance (as shown in FIG. 4-3, BLER performance of the polar code used in this scheme is compared with BLER performance of the LDPC code used in LDPC ay); and a design of a maximum code rate of 15/16 and/or 8 QAM is used in the MCS table. This improves maximum system throughput and simultaneously supports finer adjustment of system efficiency.

S103: The receiving device performs FDSS inverse processing on a fourth signal, to obtain a fifth signal.

In this embodiment, after receiving the target signal in step S102, the second communication apparatus used as the receiving device determines the fourth signal based on the target signal, and performs FDSS inverse processing on the fourth signal in step S103, to obtain a fifth signal. The fifth signal is used to perform polar decoding based on the modulation and coding scheme.

It should be noted that the target signal is used to determine the fourth signal, and may specifically indicate that the second communication apparatus used as the receiving device may determine the fourth signal in step S103 through the target signal. A specific determining process may be a signal obtained by performing DFT processing on at least the target signal, and the signal may alternatively be obtained by performing another processing process, for example, serial/parallel (S/P) conversion, cyclic prefix (cyclic prefix, CP) removal, or another processing process. This is not limited herein.

In a possible implementation, a process in which the second communication apparatus used as the receiving device performs FDSS inverse processing on the fourth signal in step S103, to obtain the fifth signal may specifically include: The second communication apparatus used as the receiving device first performs filtering processing on the fourth signal, to obtain a sixth signal; and then, the second communication apparatus performs IDFT processing on the sixth signal, to obtain the fifth signal. After obtaining the target signal, the second communication apparatus used as the receiving device may implement different FDSS inverse processing based on different filters in the second communication apparatus. When the target signal from the sending device is filtered by using a root-raised cosine (root-raised cosine, RRC) filter, the receiving device needs to perform filtering processing in a process of performing inverse processing on the fourth signal determined by the target signal, and performs IDFT processing after the filtering processing, to obtain the fifth signal. The IDFT processing is used to perform transform processing on a frequency domain signal to obtain a time domain signal, so that the fifth signal may subsequently obtain corresponding bit information through symbol demodulation.

In a possible implementation, a process in which the second communication apparatus used as the receiving device performs FDSS inverse processing on the fourth signal in step S103, to obtain the fifth signal may specifically include: The second communication apparatus performs IDFT processing on the fourth signal, to obtain the fifth signal. After obtaining the target signal, the second communication apparatus used as the receiving device may implement different FDSS inverse processing based on different filters in the second communication apparatus. When the target signal from the sending device is filtered by using a raised cosine (raised cosine, RC) filter, the receiving device may not need to perform filtering processing in a process of performing inverse processing on the fourth signal determined by the target signal, to be specific, directly performs IDFT processing on the fourth signal, to obtain the fifth signal. The IDFT processing is used to perform transform processing on the frequency domain signal to obtain the time domain signal, so that the fifth signal may subsequently obtain corresponding bit information through symbol demodulation.

It should be noted that as a special implementation form of the IDFT, inverse fast fourier transform (inverse fast fourier transform, IFFT) is a fast algorithm for implementing the IDFT, and the foregoing IDFT processing process may also be implemented through an IFFT processing process.

In a possible implementation, the fifth signal obtained by the second communication apparatus used as the receiving device in step S103 may be a signal obtained through processing based on the first DFT point quantity. The fourth signal determined based on the target signal is a signal obtained by performing DFT processing on the target signal based on the second DFT point quantity. Specifically, the fifth signal may be specifically a time domain signal that is used to perform polar decoding based on the modulation and coding scheme and that is obtained after IDFT processing is performed on the sixth signal based on the first DFT point quantity. In addition, the DFT processing is used to perform transform processing on the time domain signal to obtain the frequency domain signal. In other words, the fourth signal may be a frequency domain signal obtained by performing DFT processing on the target signal based on the second DFT point quantity.

Similarly, as a special implementation form of the DFT, fast fourier transform (fast fourier transform, FFT) is a fast algorithm for implementing the DFT. Therefore, the foregoing DFT processing process may also be implemented through an FFT processing process.

In a possible implementation, a numerical ratio of the first DFT point quantity to the second DFT point quantity is 2 to 3. Because the numerical ratio of the first DFT point quantity to the second DFT point quantity is 2 to 3, it can be learned that a maximum alpha value of a filter (filter) used to implement filtering processing may be 0.5. The alpha value of the filter is used to limit a design of the filter. For example, when a root-raised cosine filter is used, the alpha value is a roll-off factor of the root-raised cosine filter. A design of a filter required by the sending device may be conveniently guided based on the alpha value.

Optionally, when the numerical ratio of the first DFT point quantity to the second DFT point quantity is 2 to 3, a value of the first DFT point quantity may be 512, and a value of the second DFT point quantity may be 768; or a value of the first DFT point quantity may be 1024, and a value of the second DFT point quantity may be 1536; or another value combination, which is not limited herein.

In a possible implementation, a numerical ratio of the first DFT point quantity to the second DFT point quantity is 4 to 5. Because the numerical ratio of the first DFT point quantity to the second DFT point quantity is 4 to 5, it can be learned that an alpha value of a filter (filter) used to implement filtering processing may be 0.25. The alpha value of the filter is used to limit a design of the filter. For example, when a root-raised cosine filter is used, the alpha value is a roll-off factor of the root-raised cosine filter. A design of a filter required by the sending device may be conveniently guided based on the alpha value.

Optionally, when the numerical ratio of the first DFT point quantity to the second DFT point quantity is 4 to 5, a value of the first DFT point quantity may be 512, and a value of the second DFT point quantity may be 640; or a value of the first DFT point quantity may be 1024, and a value of the second DFT point quantity may be 1280; or another value combination, which is not limited herein.

In a possible implementation, a sampling rate of a baseband signal of the second communication apparatus is a positive integer multiple of 30.72 megahertz MHz. To support normal operation of the second communication apparatus in another communication system (a communication system limiting the sampling rate of the baseband signal to 30.72 MHz), the sampling rate of the baseband signal of the second communication apparatus may be set to the positive integer multiple of 30.72 MHz, to improve compatibility of the second communication apparatus in different communication systems, and flexible configuration may also be performed based on a system bandwidth of the communication system, to further improve communication energy efficiency.

It should be noted that the sampling rate of the baseband signal of the second communication apparatus is a positive integer multiple of 30.72 MHz. For example, when the system bandwidth is 2.5 GHz, a value of the positive integer multiple may be 8, namely, 2.4576 GHz; or when the system bandwidth is 5.0 GHz, a value of the positive integer multiple may be 16, namely, 4.9152 GHz; or when the system bandwidth is 7.5 GHz, a value of the positive integer multiple may be 24, namely, 7.3728 GHz; or when the system bandwidth is 10.0 GHz, a value of the positive integer multiple may be 32, namely, 9.8304 GHz; or a value of the positive integer multiple is another value, and is not limited herein. In other words, different multiples of a positive integer multiple of 30.72 MHz are selected in different system bandwidths, so that spectrum utilization of a communication system in which the second communication apparatus is located is improved on a premise that compatibility of the second communication apparatus in different communication systems is improved.

Specifically, the fifth signal obtained by the second communication apparatus used as the receiving device in step S103 is used to perform polar decoding based on the modulation and coding scheme. In other words, the receiving device may perform polar encoding on the fifth signal based on the modulation and coding scheme to obtain corresponding bit information. Specifically, the modulation and coding scheme may include a plurality of pieces of configuration information. In addition, any piece of configuration information includes at least a code rate. When a code rate of the modulation and coding scheme includes 15/16, compared with another code rate (for example, 1/2, 3/4, 7/8, or the like) implementation commonly used in a scenario in which an operating frequency band is between 30 gigahertz GHz and 300 GHz, a high throughput rate may be achieved by using a high code rate, to meet a requirement for a high throughput rate in a short-range wireless communication technology.

Optionally, the code rate of the modulation and coding scheme may further include one or more of 1/2, 3/4, 5/8, 7/8, and 13/16.

It should be noted that the modulation and coding scheme may be implemented in a plurality of different forms, such as a text, a table, a schematic diagram, and the like. This is not limited herein. For example, when the modulation and coding scheme is implemented through the table, the modulation and coding scheme may be a modulation and coding scheme (modulation and coding scheme, MCS) table.

In addition, the fifth signal obtained by the second communication apparatus used as the receiving device in step S 103 is used to perform polar decoding based on the modulation and coding scheme. In other words, the receiving device performs polar encoding on the fifth signal based on the modulation and coding scheme to obtain corresponding bit information. Specifically, the modulation and coding scheme may include a plurality of pieces of configuration information. In addition, any piece of configuration information includes at least a modulation manner. When the modulation manner of the modulation and coding scheme includes the 8 QAM, compared with another modulation manner (for example, a large span from low spectral efficiency corresponding to quadrature phase shift keying (Quadrature Phase Shift Keying, QPSK) to high spectral efficiency corresponding to 16-order QAM) implementation commonly used in a scenario in which an operating frequency band is between 30 gigahertz GHz and 300 GHz. By using the modulation manner of the 8 QAM, spectral efficiency of the second communication apparatus may smoothly transition from a modulation manner of the low spectral efficiency to a modulation manner of the high spectral efficiency. This improves throughput performance of the communication system.

Optionally, the code rate of the modulation and coding scheme may further include one or more of binary phase shift keying (binary phase shift keying, BPSK), QPSK, and 16 QAM.

Specifically, the receiving device performs processing on the received target signal in step S 103 to obtain the fifth signal, and may obtain bit information based on the fifth signal. For an implementation process, refer to step S101 and step S 102. An inverse process of a process in which the sending device performs processing on the bit information to obtain the target signal and send the target signal.

For example, for a processing process of the receiving device, refer to an inverse process of a description process of modularizing the sending device in FIG. 4-1. In other words, a plurality of processing modules similar to those shown in FIG. 4-1 may also be disposed in the receiving device. The target signal sequentially passes through a DAC module, a parallel/serial (P/S) conversion module, a CP removal module, an IFFT module, a filter (Filter) module, a DFT module, an S/P module, a modulation (Modulation) module, a polar code decoding module, and the like.

It should be noted that in a processing process of the sending device shown in FIG. 4-1, information bits are processed to sequentially obtain a first signal, a possible third signal, a second signal, and a target signal; and in a corresponding inverse process, namely, in a processing process of the receiving device, the target signal is processed to sequentially obtain a fourth signal, a possibly existing sixth signal, a fifth signal, and an information bit. Whether a plurality of processing modules in the sending device and a plurality of corresponding processing modules in the receiving device are implemented through a hardware module or through simulation of a software module, due to different physical features of devices and losses of transmission on a channel, a specific loss or distortion may easily occur in the signals and the signals may not be completely consistent. In other words, the first signal in the sending device and the fifth signal in the receiving device may not be completely the same. Similarly, the third signal in the sending device and the sixth signal in the receiving device may not be completely the same. The second signal in the sending device and the fourth signal in the receiving device may not be completely the same. However, it is generally considered that there is a difference between the information bits in the sending device and the information bits in the receiving device. Cancellation may be performed to some extent by optimizing processing in the receiving device (and/or the sending device), so that data that is intended to be sent by the sending device may be completely and accurately received by the receiving device.

In addition, in a process in which the receiving device processes the target signal, still refer to a plurality of possible designs of the numerology related to Table 1 to Table 10 and descriptions of the MCS table that are described in step S102. Details are not described herein again.

In this embodiment, the sending device performs FDSS processing on the first signal obtained by performing polar encoding based on the modulation and coding scheme, to obtain the second signal, and sends, to the receiving device, the target signal obtained based on the second signal. In the communication method,, the second signal is obtained by using FDSS waveform processing, so that a PAPR of the target signal sent by the sending device can be reduced, to reduce costs and power consumption of a transmitter. In addition, a polar encoding manner is used to obtain the first signal. Compared with high power consumption in a decoding process in a conventional encoding manner of a low density parity code (low density parity code, LDPC), decoding power consumption of the receiving device of the target signal can be reduced, and communication energy efficiency can be improved.

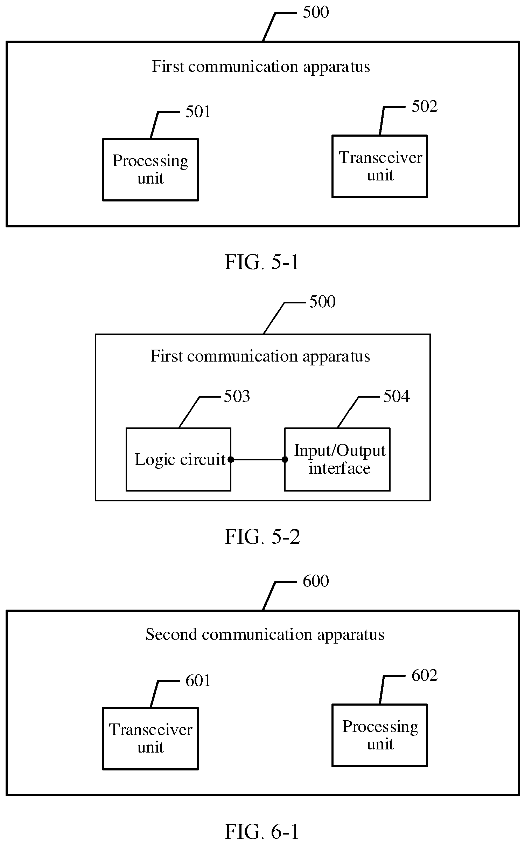

Refer to FIG. 5-1. Embodiments of this application provide a first communication apparatus 500. The first communication apparatus 500 may implement functions of a sending device in the foregoing method embodiments, and therefore may also implement beneficial effects of the foregoing method embodiments. In embodiments of this application, the first communication apparatus 500 may be a sending device, or may be an integrated circuit or a component, for example, a chip, inside the sending device.

An operating frequency band of the first communication apparatus 500 is between 30 GHz and 300 GHz, and the apparatus 500 includes:
a processing unit 501, configured to perform FDSS processing on a first signal, to obtain a second signal, where the first signal is a signal obtained by performing polar encoding based on a modulation and coding scheme; and
a transceiver unit 502, configured to send a target signal, where the target signal is a signal obtained based on the second signal.

In a possible implementation, the processing unit 501 is specifically configured to:
perform discrete fourier transform DFT processing on the first signal, to obtain a third signal; and
perform filtering processing on the third signal, to obtain the second signal.

In a possible implementation, the third signal is a signal obtained by performing processing based on a first DFT point quantity, and the target signal is a signal obtained by performing IDFT processing on the second signal based on a second DFT point quantity.

In a possible implementation, a numerical ratio of the first DFT point quantity to the second DFT point quantity is 2 to 3.

In a possible implementation, a numerical ratio of the first DFT point quantity to the second DFT point quantity is 4 to 5.

In a possible implementation, a sampling rate of a baseband signal of the first communication apparatus 500 is a positive integer multiple of 30.72 megahertz MHz.

In a possible implementation, a code rate of the modulation and coding scheme includes at least 15/16.

In a possible implementation, a modulation manner of the modulation and coding scheme includes at least 8-order quadrature amplitude modulation.

In a possible implementation, a subcarrier spacing of the target signal is a positive integer multiple of 1.6 MHz or a positive integer multiple of 1.92 MHz.

In a possible implementation, the target signal further includes a cyclic prefix CP, and a time length of the CP includes at least one of the following:
26.04 nanoseconds ns, 104.16 ns, 52.08 ns, and 208.32 ns.

It should be noted that for details such as an information execution process of a unit of the first communication apparatus 500, refer to descriptions in the foregoing method embodiments of this application. Details are not described herein again.

FIG. 5-2 is another schematic diagram of a structure of a first communication apparatus 500 according to this application. The first communication apparatus 500 includes a logic circuit 503 and an input/output interface 504. The first communication apparatus 500 may be a chip or an integrated circuit.

The transceiver unit 501 shown in FIG. 5-1 may be a communication interface. The communication interface may be the input/output interface 504 in FIG. 5-2. The input/output interface 504 may include an input interface and an output interface. Alternatively, the communication interface may be a transceiver circuit, and the transceiver circuit may include an input interface circuit and an output interface circuit. In addition, the processing unit 502 shown in FIG. 5-1 may be the logic circuit 503 in FIG. 5-2.

Specifically, the logic circuit 503 is configured to perform FDSS processing on a first signal, to obtain a second signal, where the first signal is a signal obtained by performing polar encoding based on a modulation and coding scheme; and the input/output interface 504 is configured to send a target signal, where the target signal is a signal obtained based on the second signal.

In a possible implementation, the logic circuit 503 may further perform other steps performed by the processing unit 502 and implement corresponding beneficial effects, and the input/output interface 504 may further perform other steps performed by the transceiver unit 501 and implement corresponding beneficial effects. Details are not described herein again.

In a possible implementation, the logic circuit 503 may be a processing apparatus, and some or all functions of the processing apparatus may be implemented through software. Some or all functions of the processing apparatus may be implemented through software.

Optionally, the processing apparatus may include a memory and a processor. The memory is configured to store a computer program, and the processor reads and executes the computer program stored in the memory, to perform corresponding processing and/or steps in any method embodiment.

Optionally, the processing apparatus may include only a processor. A memory configured to store a computer program is located outside the processing apparatus, and the processor is connected to the memory through a circuit/wire, to read and execute the computer program stored in the memory. The memory and the processor may be integrated together, or may be physically independent of each other.

Optionally, the processing apparatus may be one or more chips, or one or more integrated circuits. For example, the processing apparatus may be one or more field-programmable gate arrays (field-programmable gate array, FPGA), application-specific integrated circuits (application-specific integrated circuit, ASIC), system on chips (system on chip, SoC), central processor units (central processor unit, CPU), network processors (network processor, NP), digital signal processors (digital signal processor, DSP), micro controller units (micro controller unit, MCU), programmable logic devices (programmable logic device, PLD), or another integrated chip, or any combination of the foregoing chips or processors.

Refer to FIG. 6-1. Embodiments of this application provide a second communication apparatus 600. The second communication apparatus 600 may implement functions of a receiving device in the foregoing method embodiments, and therefore may also implement beneficial effects of the foregoing method embodiments. In embodiments of this application, the second communication apparatus 600 may be a receiving device, or may be an integrated circuit or component, for example, a chip, inside the receiving device.

An operating frequency band of the second communication apparatus 600 is between 30 GHz and 300 GHz, and the apparatus 600 includes:
a transceiver unit 601, configured to obtain a target signal, where the target signal is used to determine a fourth signal; and
a processing unit 602, configured to perform FDSS inverse processing on the fourth signal, to obtain a fifth signal, where the fifth signal is used to perform polar decoding based on a modulation and coding scheme.

In a possible implementation, the processing unit 601 is specifically configured to:
perform filtering processing on the fourth signal, to obtain a sixth signal; and
perform IDFT processing on the sixth signal, to obtain the fifth signal.

In a possible implementation, the processing unit 601 is specifically configured to:
perform IDFT processing on the fourth signal, to obtain the fifth signal.

In a possible implementation, the fifth signal is a signal obtained by performing processing based on a first DFT point quantity, and the fourth signal is a signal obtained by performing DFT processing on the target signal based on a second DFT point quantity.

In a possible implementation, a numerical ratio of the first DFT point quantity to the second DFT point quantity is 2 to 3.

In a possible implementation, a numerical ratio of the first DFT point quantity to the second DFT point quantity is 4 to 5.

In a possible implementation, a sampling rate of a baseband signal of the second communication apparatus 600 is a positive integer multiple of 30.72 megahertz MHz.

In a possible implementation, a code rate of the modulation and coding scheme includes at least 15/16.

In a possible implementation, a modulation manner of the modulation and coding scheme includes at least 8-order quadrature amplitude modulation.

In a possible implementation, a subcarrier spacing of the target signal is a positive integer multiple of 1.6 MHz or a positive integer multiple of 1.92 MHz.

In a possible implementation, the target signal further includes a cyclic prefix CP, and a time length of the CP includes at least one of the following:
26.04 nanoseconds ns, 104.16 ns, 52.08 ns, and 208.32 ns.

It should be noted that for details such as an information execution process of the foregoing unit of the second communication apparatus 600, refer to descriptions in the foregoing method embodiments of this application. Details are not described herein again.

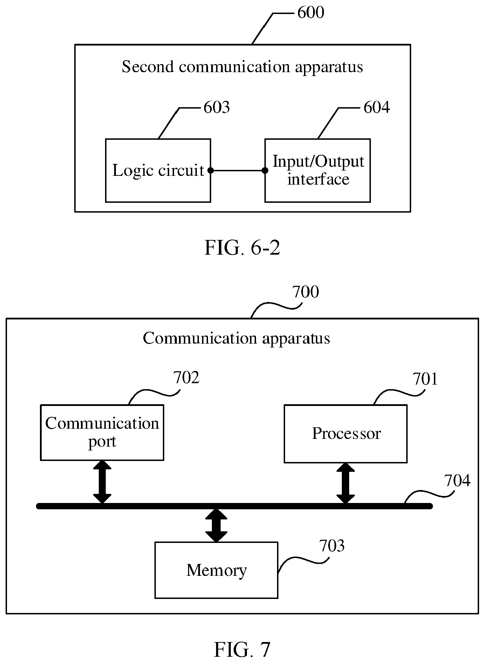

FIG. 6-2 is another schematic diagram of a structure of a second communication apparatus 600 according to this application. The second communication apparatus 600 includes a logic circuit 603 and an input/output interface 604. The second communication apparatus 600 may be a chip or an integrated circuit.

The transceiver unit 601 shown in FIG. 6-1 may be a communication interface. The communication interface may be the input/output interface 604 in FIG. 6-2. The input/output interface 604 may include an input interface and an output interface. Alternatively, the communication interface may be a transceiver circuit, and the transceiver circuit may include an input interface circuit and an output interface circuit. In addition, the processing unit 602 shown in FIG. 6-1 may be the logic circuit 603 in FIG. 6-2.

Specifically, the input/output interface 604 is configured to obtain a target signal, where the target signal is used to determine a fourth signal; and the logic circuit 603 is configured to perform FDSS inverse processing on the fourth signal, to obtain a fifth signal, where the fifth signal is used to perform polar decoding based on a modulation and coding scheme.

In a possible implementation, the logic circuit 603 may further perform other steps performed by the processing unit 602 and implement corresponding beneficial effects, and the input/output interface 604 may further perform other steps performed by the transceiver unit 601 and implement corresponding beneficial effects. Details are not described herein again.

In a possible implementation, the logic circuit 603 may be a processing apparatus, and some or all functions of the processing apparatus may be implemented through software. Some or all functions of the processing apparatus may be implemented through software.

Optionally, the processing apparatus may include a memory and a processor. The memory is configured to store a computer program, and the processor reads and executes the computer program stored in the memory, to perform corresponding processing and/or steps in any method embodiment.

Optionally, the processing apparatus may include only a processor. A memory configured to store a computer program is located outside the processing apparatus, and the processor is connected to the memory through a circuit/wire, to read and execute the computer program stored in the memory. The memory and the processor may be integrated together, or may be physically independent of each other.

Optionally, the processing apparatus may be one or more chips, or one or more integrated circuits. For example, the processing apparatus may be one or more field-programmable gate arrays (field-programmable gate array, FPGA), application-specific integrated circuits (application-specific integrated circuit, ASIC), system on chips (system on chip, SoC), central processor units (central processor unit, CPU), network processors (network processor, NP), digital signal processors (digital signal processor, DSP), micro controller units (micro controller unit, MCU), programmable logic devices (programmable logic device, PLD), or another integrated chip, or any combination of the foregoing chips or processors.

FIG. 7 shows a communication apparatus 700 involved in the foregoing embodiment according to an embodiment of this application. The communication apparatus 700 may be specifically a first communication apparatus used as a sending device or a second communication apparatus used as a receiving device in the foregoing embodiment. In an example shown in FIG. 7, a sending device or a receiving device is implemented through a terminal device (or a component in a terminal device). In a possible schematic diagram of a logical structure of the communication apparatus 700, the communication apparatus 700 may include but is not limited to at least one processor 701 and a communication port 702. Further, optionally, the apparatus may further include at least one of a memory 703 and a bus 704. In embodiments of this application, the at least one processor 701 is configured to perform control processing on an action of the communication apparatus 700.

In addition, the processor 701 may be a central processing unit, a general-purpose processor, a digital signal processor, an application-specific integrated circuit, a field programmable gate array, another programmable logic device, a transistor logic device, a hardware component, or any combination thereof. The processing module may implement or execute various example logical blocks, modules, and circuits described with reference to content disclosed in this application. Alternatively, the processor may be a combination of processors implementing a computing function, for example, a combination of one or more microprocessors, or a combination of a digital signal processor and a microprocessor. It may be clearly understood by a person skilled in the art that, for convenient and brief description, for a detailed working process of the foregoing system, apparatus, and unit, refer to a corresponding process in the foregoing method embodiments, and details are not described herein again.

It should be noted that the communication apparatus 700 shown in FIG. 7 may be specifically configured to implement steps implemented by the sending device or the receiving device in the foregoing method embodiments, and implement technical effects corresponding to the sending device or the receiving device. For a specific implementation of the communication apparatus shown in FIG. 7, refer to descriptions in the foregoing method embodiments. Details are not described herein again.

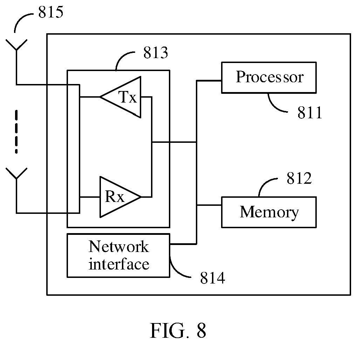

FIG. 8 is a schematic diagram of a structure of a communication apparatus 800 in the foregoing embodiments according to an embodiment of this application. The communication apparatus 800 may be specifically a first communication apparatus used as a sending device or a second communication apparatus used as a receiving device in the foregoing embodiments. In an example shown in FIG. 8, the sending device or the receiving device is implemented through a network device (or a component in a network device). For a structure of the communication apparatus, refer to the structure shown in FIG. 8.

The communication apparatus 800 includes at least one processor 811 and at least one network interface 814. Further, optionally, the communication apparatus further includes at least one memory 812, at least one transceiver 813, and one or more antennas 815. The processor 811, the memory 812, and the transceiver 813 are connected to the network interface 814, for example, through a bus. In embodiments of this application, the connection may include various interfaces, transmission lines, buses, or the like, and this is not limited in this embodiment. The antenna 815 is connected to the transceiver 813. The network interface 814 is configured to enable the communication apparatus to communicate with another communication device through a communication link. For example, the network interface 814 may include a network interface, for example, an S1 interface, between the communication apparatus and a core network device. The network interface may include a network interface, for example, an X2 or an Xn interface, between the communication apparatus and another communication apparatus (for example, another network device or a core network device).

The processor 811 is mainly configured to process a communication protocol and communication data, control the entire communication apparatus, execute a software program, and process data of the software program, for example, is configured to support the communication apparatus in performing actions described in the embodiments. The communication apparatus may include a baseband processor and a central processing unit. The baseband processor is mainly configured to process the communication protocol and the communication data. The central processing unit is mainly configured to: control an entire terminal device, execute the software program, and process the data of the software program. The processor 811 in FIG. 8 may integrate functions of the baseband processor and the central processing unit. A person skilled in the art may understand that the baseband processor and the central processing unit each may be an independent processor, and are interconnected through a technology such as a bus. A person skilled in the art may understand that the terminal device may include a plurality of baseband processors to adapt to different network standards, and the terminal device may include a plurality of central processing units to enhance processing capabilities of the terminal device, and components of the terminal device may be connected by using various buses. The baseband processor may also be expressed as a baseband processing circuit or a baseband processing chip. The central processing unit may alternatively be expressed as a central processing circuit or a central processing chip. The function of processing the communication protocol and the communication data may be built in the processor, or may be stored in the memory in a form of a software program, and the processor executes the software program to implement a baseband processing function.

The memory is mainly configured to store the software program and data. The memory 812 may exist independently, and is connected to the processor 811. Optionally, the memory 812 may be integrated with the processor 811, for example, integrated into a chip. The memory 812 may store program code for executing the technical solutions in embodiments of this application, and the processor 811 controls execution of the program code. Various types of computer program code that are executed may also be considered as drivers of the processor 811.

FIG. 8 shows only one memory and one processor. In an actual terminal device, there may be a plurality of processors and a plurality of memories. The memory may also be referred to as a storage medium, a storage device, or the like. The memory may be a storage element located on a same chip as the processor, namely, an on-chip storage element, or may be an independent storage element. This is not limited in embodiments of this application.

The transceiver 813 may be configured to support receiving or sending of a radio frequency signal between the communication apparatus and a terminal, and the transceiver 813 may be connected to the antenna 815. The transceiver 813 includes a transmitter Tx and a receiver Rx. Specifically, the one or more antennas 815 may receive a radio frequency signal. The receiver Rx of the transceiver 813 is configured to receive the radio frequency signal from the antenna, convert the radio frequency signal into a digital baseband signal or a digital intermediate frequency signal, and provide the digital baseband signal or the digital intermediate frequency signal for the processor 811, so that the processor 811 performs further processing on the digital baseband signal or the digital intermediate frequency signal, for example, performs demodulation processing and decoding processing. In addition, the transmitter Tx of the transceiver 813 is further configured to: receive a modulated digital baseband signal or a modulated digital intermediate frequency signal from the processor 811, convert the modulated digital baseband signal or the digital intermediate frequency signal into a radio frequency signal, and transmit the radio frequency signal through the one or more antennas 815. Specifically, the receiver Rx may selectively perform one or more levels of frequency down-mixing processing and analog-to-digital conversion processing on the radio frequency signal to obtain the digital baseband signal or the digital intermediate frequency signal. A sequence of the frequency down-mixing processing and the analog-to-digital conversion processing is adjustable. The transmitter Tx may selectively perform one or more levels of frequency up-mixing processing and digital-to-analog conversion processing on the modulated digital baseband signal or the modulated digital intermediate frequency signal to obtain the radio frequency signal. A sequence of the frequency up-mixing processing and the digital-to-analog conversion processing is adjustable. The digital baseband signal and the digital intermediate frequency signal may be collectively referred to as digital signals.

The transceiver 813 may also be referred to as a transceiver unit, a transceiver, a transceiver apparatus, or the like. Optionally, a component that is configured to implement a receiving function and that is in the transceiver unit may be considered as a receiving unit, and a component that is configured to implement a sending function and that is in the transceiver unit may be considered as a sending unit. In other words, the transceiver unit includes the receiving unit and the sending unit. The receiving unit may also be referred to as a receiver, an input port, a receiving circuit, or the like. The sending unit may be referred to as a transmitter, a transmitting circuit, or the like.

It should be noted that the communication apparatus 800 shown in FIG. 8 may be specifically configured to implement steps implemented by the sending device or the receiving device in the foregoing method embodiments, and implement technical effects corresponding to the sending device or the receiving device. For a specific implementation of the communication apparatus 800 shown in FIG. 8, refer to the description in the foregoing method embodiments. Details are not described herein again.

Embodiments of this application further provide a computer-readable storage medium that stores one or more computer-executable instructions. When the computer-executable instructions are executed by a processor, the processor performs the method described in a possible implementation of the terminal device in the foregoing embodiments, namely, the sending device in the foregoing method embodiments.

Embodiments of this application further provide a computer-readable storage medium that stores one or more computer-executable instructions. When the computer-executable instructions are executed by a processor, the processor performs the method described in a possible implementation of the network device in the foregoing embodiments, namely, the receiving device in the foregoing method embodiments.

Embodiments of this application further provide a computer program product (or referred to as a computer program) that stores one or more computers. When the computer program product is executed by the processor, the processor performs the method in the foregoing possible implementations of the terminal device, namely, the sending device in the foregoing method embodiments.

Embodiments of this application further provide a computer program product that stores one or more computers. When the computer program product is executed by the processor, the processor performs the method in the foregoing possible implementations of the network device, namely, the receiving device in the foregoing method embodiments.

Embodiments of this application further provide a chip system. The chip system includes at least one processor, configured to support a first communication apparatus in implementing functions in the foregoing possible implementations of the first communication apparatus. Optionally, the chip system further includes an interface circuit, and the interface circuit provides program instructions and/or data for the at least one processor. In a possible design, the chip system may further include a memory. The memory is configured to store program instructions and data that are necessary for the first communication apparatus. The chip system may include a chip, or may include a chip and another discrete component. The first communication apparatus may be specifically the sending device in the foregoing method embodiments.

Embodiments of this application further provide a chip system. The chip system includes at least one processor, configured to support a second communication apparatus in implementing functions involved in the foregoing possible implementations of the second communication apparatus. Optionally, the chip system further includes an interface circuit, and the interface circuit provides program instructions and/or data for the at least one processor. In a possible design, the chip system may further include a memory. The memory is configured to store program instructions and data that are necessary for the second communication apparatus. The chip system may include a chip, or may include a chip and another discrete component. The second communication apparatus may be specifically the receiving device in the foregoing method embodiments.

Embodiments of this application further provide a communication system. The network system architecture includes the terminal device and the network device in any one of the foregoing embodiments, namely, the sending device and the receiving device in the foregoing method embodiments.

In the several embodiments provided in this application, it should be understood that the disclosed system, apparatus, and method may be implemented in other manners. For example, the described apparatus embodiment is merely an example. For example, division into the units is merely logical function division and may be other division during actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in an electronic form, a mechanical form, or another form.

The units described as separate parts may or may not be physically separate, and parts displayed as units may or may not be physical units, and may be located at one location, or may be distributed on a plurality of network units. Some or all of the units may be selected based on actual requirements to achieve the objectives of the solutions of the embodiments.

In addition, functional units in embodiments of this application may be integrated into one processing unit, or each of the units may exist alone physically, or two or more units are integrated into one unit. The integrated unit may be implemented in a form of hardware, or may be implemented in a form of a software functional unit. When the integrated unit is implemented in the form of the software function unit and sold or used as an independent product, the integrated unit may be stored in a computer-readable storage medium. Based on such an understanding, the technical solutions of this application essentially, or the part contributing to the conventional technology, or all or some of the technical solutions may be implemented in the form of a software product. The computer software product is stored in a storage medium and includes several instructions for instructing a computer device (which may be a personal computer, a server, or a network device) to perform all or some of the steps of the methods in the embodiments of this application. The foregoing storage medium includes: any medium that can store program code, such as a USB flash drive, a removable hard disk, a read-only memory (ROM, Read-Only Memory), a random access memory (RAM, Random Access Memory), a magnetic disk, or an optical disc.

## Claims

1. A communication method, applied to a first communication apparatus, wherein an operating frequency band of the first communication apparatus is between 30 gigahertz GHz and 300 GHz, and the method comprises:
performing, by the first communication apparatus, frequency domain spectrum shaping FDSS processing on a first signal, to obtain a second signal, wherein the first signal is a signal obtained by performing polar code polar encoding based on a modulation and coding scheme; and
sending, by the first communication apparatus, a target signal, wherein the target signal is a signal obtained based on the second signal.

2. The method according to claim 1, wherein the performing, by the first communication apparatus, frequency domain spectrum shaping FDSS processing on a first signal, to obtain a second signal comprises:
performing, by the first communication apparatus, discrete fourier transform DFT processing on the first signal, to obtain a third signal; and
performing, by the first communication apparatus, filtering processing on the third signal, to obtain the second signal.

3. The method according to claim 2, wherein the third signal is a signal obtained by performing processing based on a first DFT point quantity, and the target signal is a signal obtained by performing inverse discrete fourier transform IDFT processing on the second signal based on a second DFT point quantity.

4. A first communication apparatus, wherein an operating frequency band of the first communication apparatus is between 30 GHz and 300 GHz, and the apparatus comprises:
a processing unit, configured to perform FDSS processing on a first signal, to obtain a second signal, wherein the first signal is a signal obtained by performing polar encoding based on a modulation and coding scheme; and
a transceiver unit, configured to send a target signal, wherein the target signal is a signal obtained based on the second signal.

5. The apparatus according to claim 4, wherein the processing unit is specifically configured to:
perform discrete fourier transform DFT processing on the first signal, to obtain a third signal; and
perform filtering processing on the third signal, to obtain the second signal.

6. The apparatus according to claim 5, wherein the third signal is a signal obtained by performing processing based on a first DFT point quantity, and the target signal is a signal obtained by performing IDFT processing on the second signal based on a second DFT point quantity.

7. A communication method, applied to a second communication apparatus, wherein an operating frequency band of the second communication apparatus is between 30 GHz and 300 GHz, and the method comprises:
obtaining, by the second communication apparatus, a target signal, wherein the target signal is used to determine a fourth signal; and
performing, by the second communication apparatus, FDSS inverse processing on the fourth signal, to obtain a fifth signal, wherein the fifth signal is used to perform polar decoding based on a modulation and coding scheme.

8. The method according to claim 7, wherein the performing, by the second communication apparatus, FDSS inverse processing on the fourth signal, to obtain a fifth signal comprises:
performing, by the second communication apparatus, filtering processing on the fourth signal, to obtain a sixth signal; and
performing, by the second communication apparatus, IDFT processing on the sixth signal, to obtain the fifth signal.

9. The method according to claim 7, wherein the performing, by the second communication apparatus, FDSS inverse processing on the fourth signal, to obtain a fifth signal comprises:
performing, by the second communication apparatus, IDFT processing on the fourth signal, to obtain the fifth signal.

10. The method according to claim 8 or 9, wherein the fifth signal is a signal obtained by performing processing based on a first DFT point quantity, and the fourth signal is a signal obtained by performing DFT processing on the target signal based on a second DFT point quantity.

11. A second communication apparatus, wherein an operating frequency band of the second communication apparatus is between 30 GHz and 300 GHz, and the apparatus comprises:
a transceiver unit, configured to obtain a target signal, wherein the target signal is used to determine a fourth signal; and
a processing unit, configured to perform FDSS inverse processing on the fourth signal, to obtain a fifth signal, wherein the fifth signal is used to perform polar decoding based on a modulation and coding scheme.

12. The apparatus according to claim 11, wherein the processing unit is specifically configured to:
perform filtering processing on the fourth signal, to obtain a sixth signal; and
perform IDFT processing on the sixth signal, to obtain the fifth signal.

13. The apparatus according to claim 11, wherein the processing unit is specifically configured to:
perform, by the second communication apparatus, IDFT processing on the fourth signal, to obtain the fifth signal.

14. The apparatus according to claim 12 or 13, wherein the fifth signal is a signal obtained by performing processing based on a first DFT point quantity, and the fourth signal is a signal obtained by performing DFT processing on the target signal based on a second DFT point quantity.

15. The method or apparatus according to claim 3, 6, 10, or 14, wherein a numerical ratio of the first DFT point quantity to the second DFT point quantity is 2 to 3.

16. The method or apparatus according to claim 3, 6, 10, or 14, wherein a numerical ratio of the first DFT point quantity to the second DFT point quantity is 4 to 5.

17. The method or apparatus according to any one of claims 1 to 16, wherein a sampling rate of a baseband signal of the apparatus is a positive integer multiple of 30.72 megahertz MHz.

18. The method or apparatus according to any one of claims 1 to 17, wherein
a code rate of the modulation and coding scheme comprises at least 15/16.

19. The method or apparatus according to any one of claims 1 to 18, wherein
a modulation manner of the modulation and coding scheme comprises at least 8-order quadrature amplitude modulation.

20. The method or apparatus according to any one of claims 1 to 19, wherein a subcarrier spacing of the target signal is a positive integer multiple of 1.6 MHz or a positive integer multiple of 1.92 MHz.

21. The method or apparatus according to any one of claims 1 to 20, wherein the target signal further comprises a cyclic prefix CP, and a time length of the CP comprises at least one of the following:
26.04 nanoseconds ns, 104.16 ns, 52.08 ns, and 208.32 ns.

22. A communication apparatus, comprising at least one processor, coupled to a memory, wherein
the memory is configured to store a program or instructions; and
the at least one processor is configured to execute the program or the instructions, to enable the apparatus to implement the method according to any one of claims 1 to 3, 7 to 10, and 15 to 21.

23. A first communication apparatus, comprising at least one logic circuit and an input/output interface, wherein
the input/output interface is configured to output a target signal; and
the logic circuit is configured to perform the method according to any one of claims 1 to 3 and 15 to 21.

24. A second communication apparatus, comprising at least one logic circuit and an input/output interface, wherein
the input/output interface is configured to input a target signal; and
the logic circuit is configured to perform the method according to any one of claims 7 to 10 and 15 to 21.

25. A computer-readable storage medium, wherein the medium stores instructions; and when the instructions are executed by a computer, the method according to any one of claims 1 to 3, 7 to 10, and 15 to 21 is implemented.

26. A computer program product, comprising instructions; and when the instructions are run on a computer, the computer is enabled to perform the method according to any one of claims 1 to 3, 7 to 10, and 15 to 21.
